**Europäisches Patentamt**

**European Patent Office**

**Office européen des brevets**

(19)

(11) **EP 1 408 336 A2**

(12) # EUROPEAN PATENT APPLICATION

(43) Date of publication:
**14.04.2004 Bulletin 2004/16**

(51) Int Cl.⁷: $G01P\ 15/08$, $G01P\ 15/00$

(21) Application number: **03028054.9**

(22) Date of filing: **21.06.2001**

(84) Designated Contracting States:
**AT CH DE FR GB LI NL**

(30) Priority: **21.06.2000 US 212997 P**
**11.07.2000 US 217609 P**

(62) Document number(s) of the earlier application(s) in
accordance with Art. 76 EPC:
**01948555.6 / 1 311 863**

(71) Applicant: **Input/Output, Inc.**
**Stafford, TX 77477 (US)**

(72) Inventors:
• **Selvakumar, Arjun**
**Bellaire TX 77401 (US)**

• **Yu, Lianzhong**
**Bellevue WA 98005 (US)**
• **Yu, Duli**
**Sugar Land TX 77478 (US)**
• **Jones, Ben**
**Austin TX 78759 (US)**

(74) Representative: **Jeffrey, Philip Michael**
**Frank B. Dehn & Co.**
**179 Queen Victoria Street**
**London EC4V 4EL (GB)**

Remarks:
This application was filed on 08 - 12 - 2003 as a
divisional application to the application mentioned
under INID code 62.

(54) **Accelerometer with mass support springs having predetermined vibration modes**

(57) An accelerometer is disclosed comprising a measuring mass 1405 for detecting acceleration, including a housing having a cavity, one or more spring mass assemblies 1400 positioned within the cavity, wherein each spring mass assembly 1400 includes a support structure 1410, including one or more resilient folded beams 1415a-1415d coupled to the support structure 1410 and the measuring mass 1405 is coupled to the resilient folded beams 1415a-1415d, wherein one or more electrode patterns are coupled to the spring mass assembly 1400, wherein a top cap wafer, including a top capacitor electrode, is coupled to the measurement mass 1405, and a bottom cap wafer, including a bottom capacitor electrode, is also coupled to the measurement mass 1405.

FIGURE 14

**Description**

**Background of the Invention**

This invention relates generally to accelerometers and more particularly to accelerometers including a mass that is resiliently coupled to a housing.

Accelerometers are used to detect and record environmental data. In particular, accelerometers are often used in seismic applications to gather seismic data. Conventional accelerometers typically include mass resiliently coupled to a support structure by one or more resilient L-shaped members. Accelerometers that use an L-shaped resilient member to support a mass typically have difficulty providing a sensor having acceptable closed-loop stability and structural reliability.

The present invention is directed to overcoming one or more of the limitations of the existing accelerometers.

**Summary**

According to one embodiment of the present invention, an accelerometer is provided that includes a measurement mass for detecting acceleration that includes a housing having a cavity, one or more spring mass assemblies positioned within the cavity, and one or more metal electrode patterns coupled to the spring mass assembly. Each spring mass assembly includes a support structure, one or more resilient folded beams coupled to the support structure, and mass coupled to the resilient folded beams. A top cap wafer is coupled to the measurement mass that includes a top capacitor electrode. A bottom cap wafer is also coupled to the measurement mass that includes a bottom capacitor electrode.

According to another embodiment of the present invention, an accelerometer is provided that includes a measurement mass for detecting acceleration that includes a housing having a cavity, one or more spring mass assemblies positioned within the cavity, and one or more metal electrode patterns coupled to the spring mass assembly. Each spring mass assembly includes a support structure, one or more resilient S-shaped beams coupled to the support structure, and mass coupled to the resilient S-shaped beams. A top cap wafer is coupled to the measurement mass that includes a top capacitor electrode. A bottom cap wafer is also coupled to the measurement mass that includes a bottom capacitor electrode.

According to another embodiment of the present invention, an accelerometer is provided that includes a measurement mass for detecting acceleration that includes a housing having a cavity, one or more spring mass assemblies positioned within the cavity, and one or more metal electrode patterns coupled to the spring mass assembly. Each spring mass assembly includes a support structure, one or more resilient straight beams coupled to the support structure, and mass coupled to the resilient straight beams. A top cap wafer is coupled to the measurement mass that includes a top capacitor electrode. A bottom cap wafer is also coupled to the measurement mass that includes a bottom capacitor electrode.

According to another embodiment of the invention, a method of operating an accelerometer having a measurement mass positioned within a housing including top and bottom electrodes positioned between corresponding top and bottom capacitor electrodes is provided that includes resiliently coupling the measurement mass to the housing using a resilient folded beam.

According to another embodiment of the invention, a method of operating an accelerometer having a measurement mass positioned within a housing including top and bottom electrodes positioned between corresponding top and bottom capacitor electrodes is provided that includes resiliently coupling the measurement mass to the housing using a resilient S-shaped beam.

According to another embodiment of the invention, a method of operating an accelerometer having a measurement mass positioned within a housing including top and bottom electrodes positioned between corresponding top and bottom capacitor electrodes is provided that includes resiliently coupling the measurement mass to the housing using a resilient straight beam.

According to another embodiment of the invention, a method of preventing crack propagation in a micro-machined structure including a webbing artifact is provided that includes providing one or more vent holes within the webbing artifact.

According to another embodiment of the invention, a method of minimizing backside etching of elements within a micro-machined structure is provided that includes providing one or more etch-buffers adjacent to the element.

According to another embodiment of the invention, a method of protecting a mass supported within a support structure by one or more springs is provided that includes providing one or more soft-contact bumpers for preventing impacts between the mass and the support structure.

The present embodiments of the invention provide an accelerometer for providing reliable data measurements. The accelerometer includes a measurement mass that is resiliently coupled to a housing by using a folded beam, an S-shaped beam or a straight beam. In this manner, the accelerometer provides low noise as well as low temperature stability. The accelerometer further includes range-of-motion limit stops for limiting motion of the measurement mass in the lateral direction thereby enhancing the cross axis sensitivity and lateral shock tolerance of the accelerometer.

**Brief Description of the Drawings**

**FIG. 1** illustrates an embodiment of a system used to acquire environmental data measurements.

**FIG. 2** illustrates an embodiment of sensors and cabling used within the system of **FIG. 1.**

**FIG. 3a** is a cross-sectional side view of the positioning of an accelerometer within the sensor of **FIG. 1.**

**FIG. 3b** is a cross-sectional top view of the positioning of an accelerometer within the sensor of **FIG. 1.**

**FIG. 4** illustrates a top perspective view of an embodiment of the accelerometer of FIG. 3a.

**FIG. 5** illustrates a bottom perspective view of the accelerometer of **FIG. 4.**

**FIG. 6** illustrates a cross-sectional view of the accelerometer of **FIG. 4**.

**FIG. 7a** illustrates a cross-sectional view of a top cap wafer of the accelerometer of **FIG. 4.**

**FIG. 7b** illustrates a top view of the top cap wafer of **FIG. 7a**.

**FIG. 7c** illustrates a bottom view of the top cap wafer of **FIG. 7a**.

**FIG. 7d** illustrates an embodiment of an arrangement of overshock bumpers on the top cap wafer of **FIG. 7a.**

**FIG. 7e** illustrates an embodiment of an alternative arrangement of the overshock bumpers of **FIG. 7d.**

**FIG. 7f** illustrates an embodiment of an alternative arrangement of the overshock bumpers of **FIG. 7d.**

**FIG. 7g** illustrates an embodiment of an alternative arrangement of the overshock bumpers of **FIG. 7d.**

**FIG. 7h** illustrates an embodiment of an alternative arrangement of the overshock bumpers of **FIG. 7d.**

**FIG. 7i** illustrates an embodiment of an alternative arrangement of the overshock bumpers of **FIG. 7d.**

**FIG. 7j** illustrates an embodiment of an alternative arrangement of the overshock bumpers of **FIG. 7d.**

**FIG. 7k** illustrates an embodiment of an alternative arrangement of the overshock bumpers of **FIG. 7d.**

**FIG. 71** illustrates an embodiment of an alternative arrangement of the overshock bumpers of **FIG. 7d.**

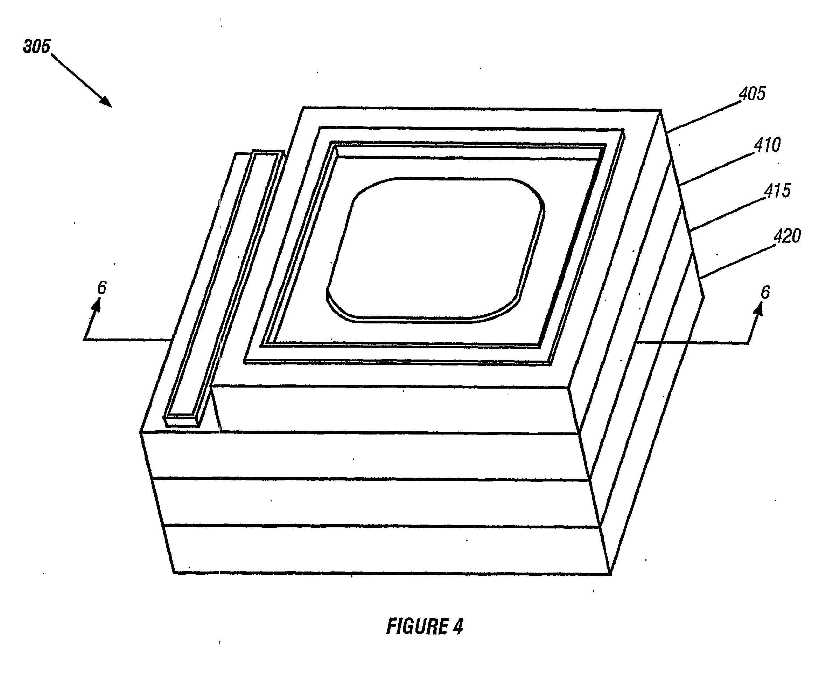

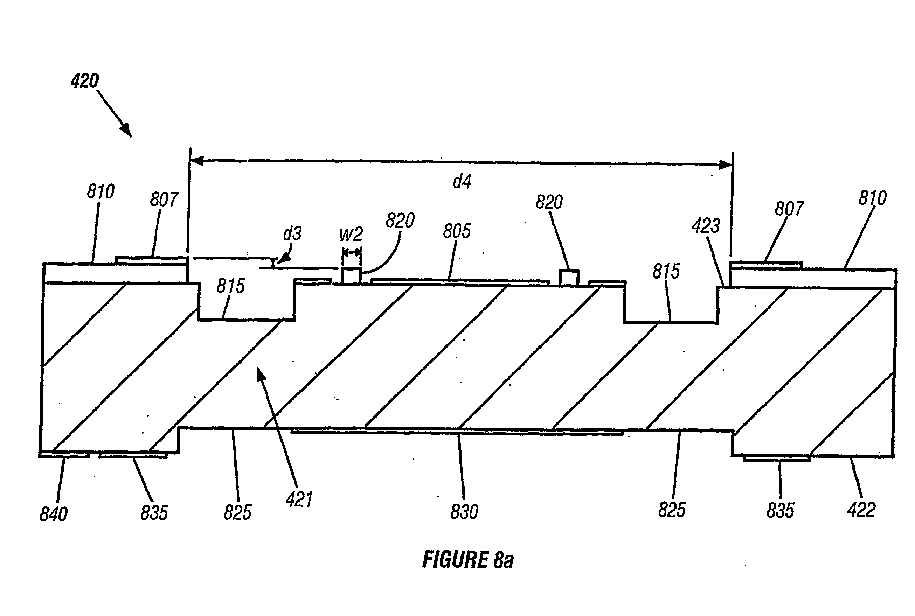

**FIG. 8a** illustrates a cross-sectional view of a bottom cap wafer of the accelerometer of **FIG. 4.**

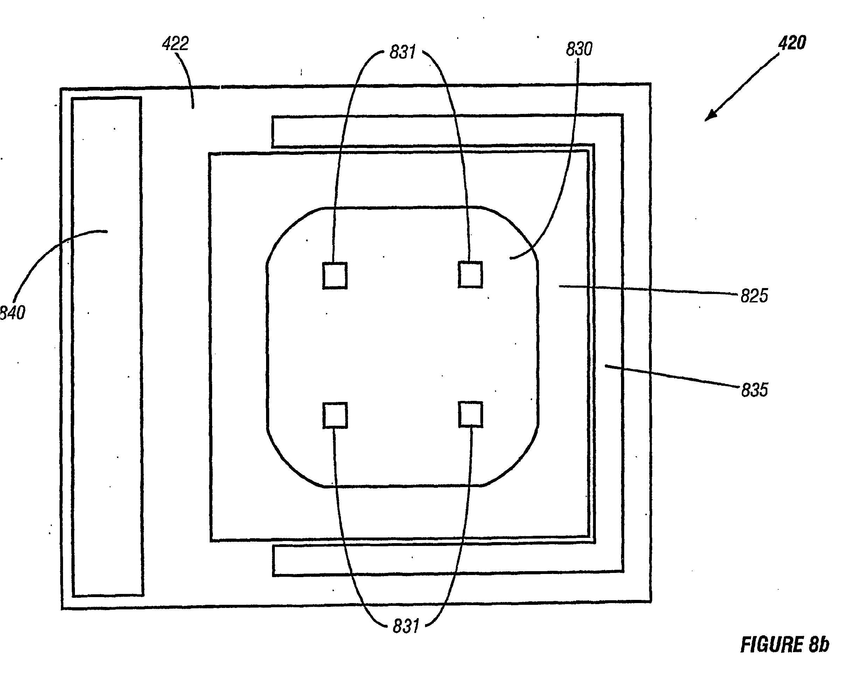

**FIG. 8b** illustrates a bottom view of the bottom cap wafer of **FIG. 8a.**

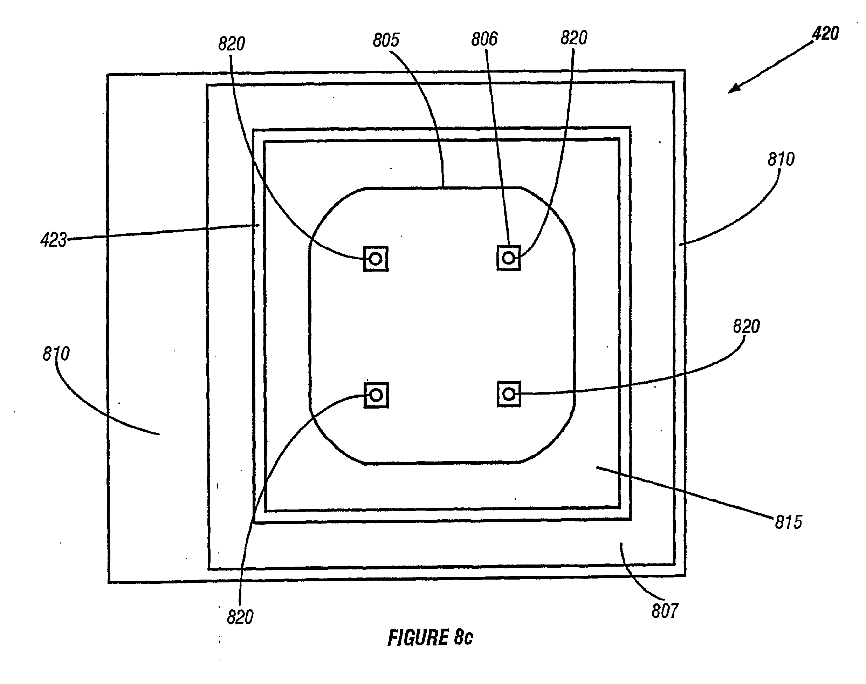

**FIG. 8c** illustrates a top view of the bottom cap wafer of **FIG. 8a.**

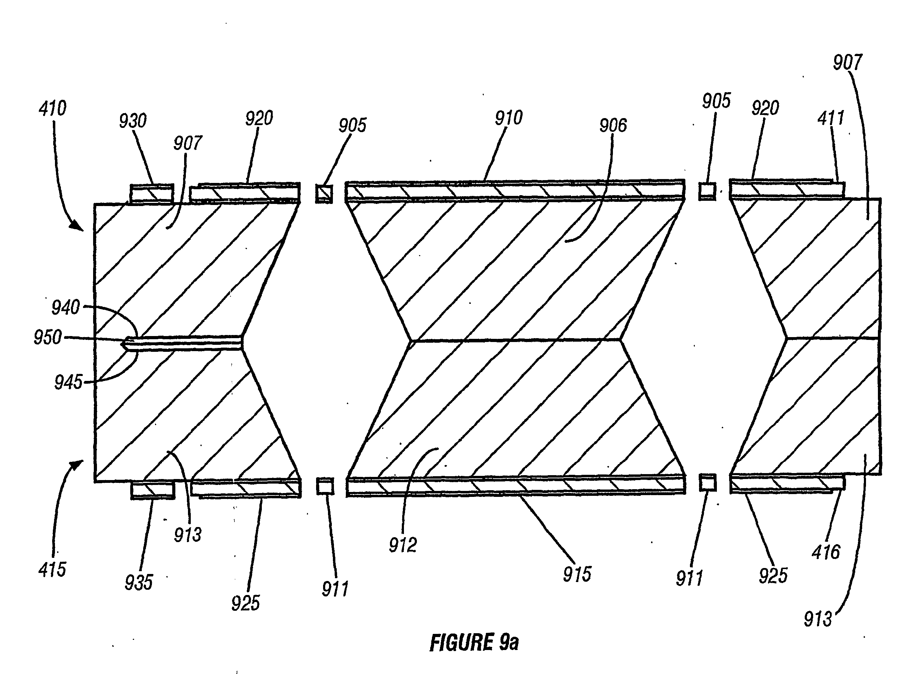

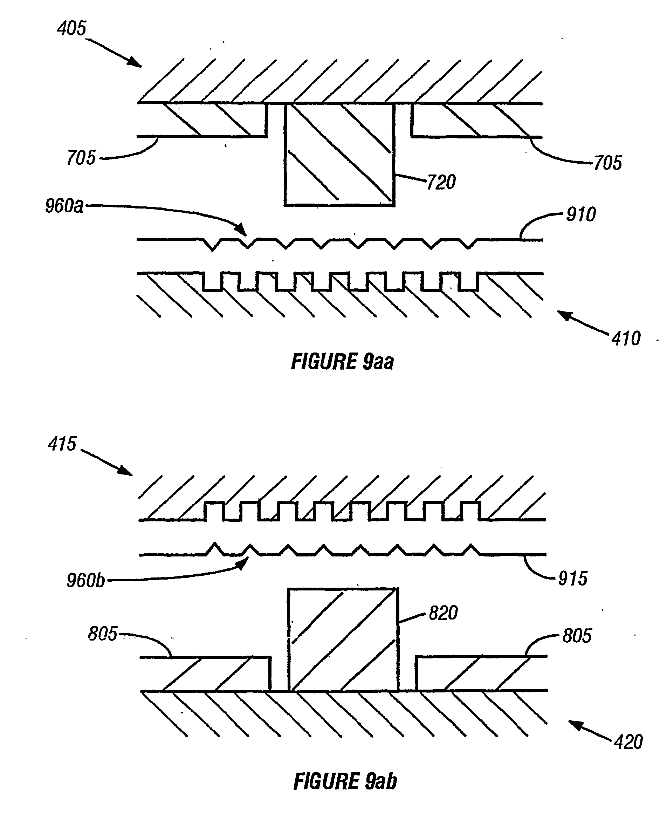

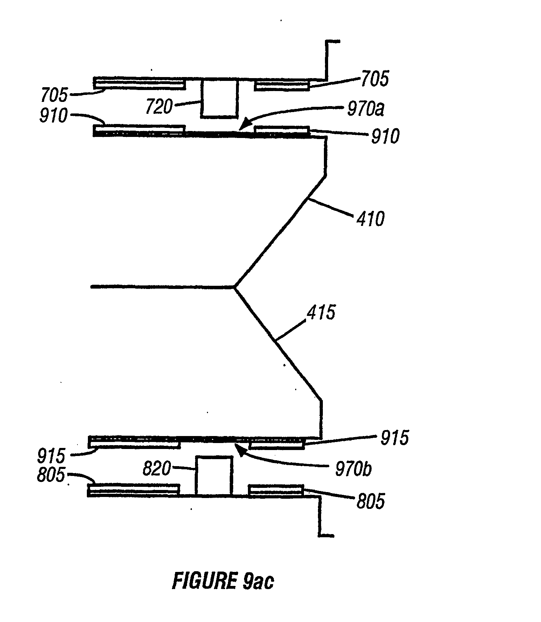

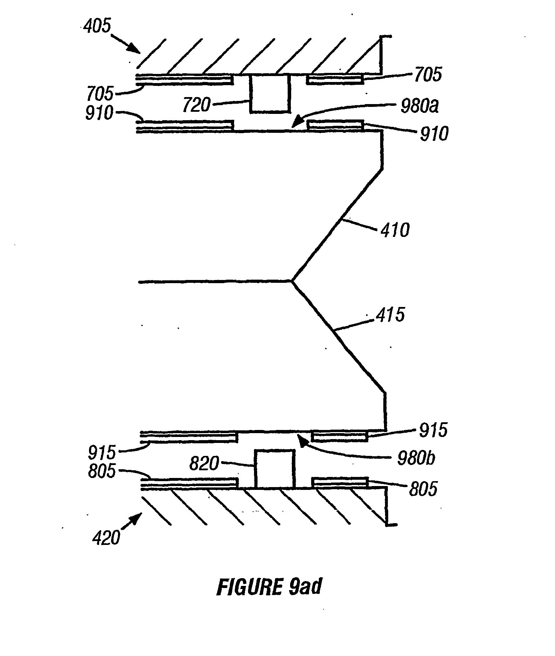

**FIG. 9a** illustrates a cross-sectional view of a mass wafer pair of the accelerometer of **FIG. 4.**

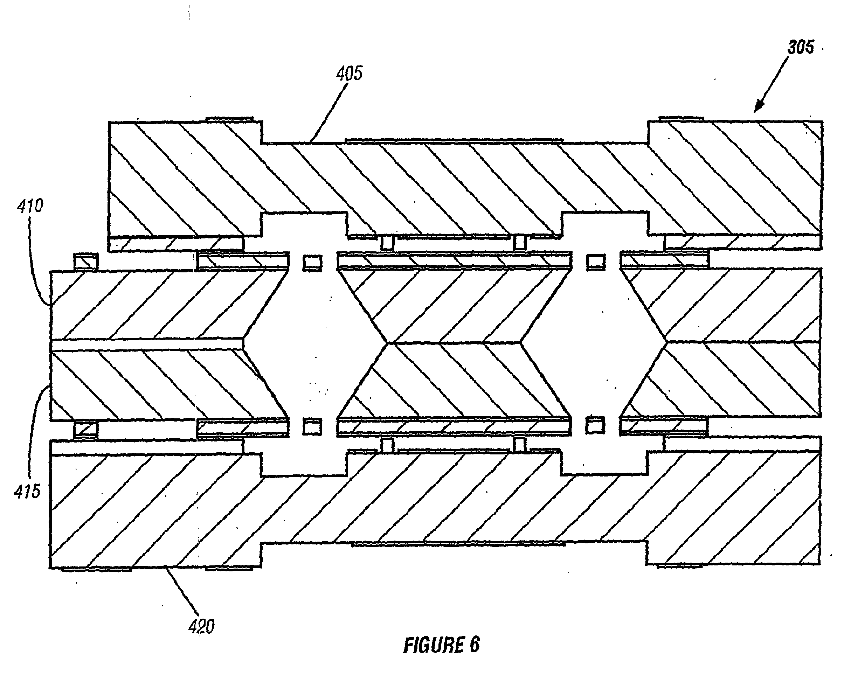

**FIG. 9aa** illustrates a cross-sectional view of a top cap overshock bumper and a patterned metal electrode within the accelerometer of **FIG. 6.**

**FIG. 9ab** illustrates a cross-sectional view of a bottom cap overshock bumper and a patterned metal electrode within the accelerometer of **FIG. 6.**

**FIG. 9ac** illustrates an embodiment of metal electrodes including reduced-thickness recesses within the accelerometer of **FIG. 6.**

**FIG. 9ad** illustrates an embodiment of metal electrodes including cavities within the accelerometer of **FIG. 6.**

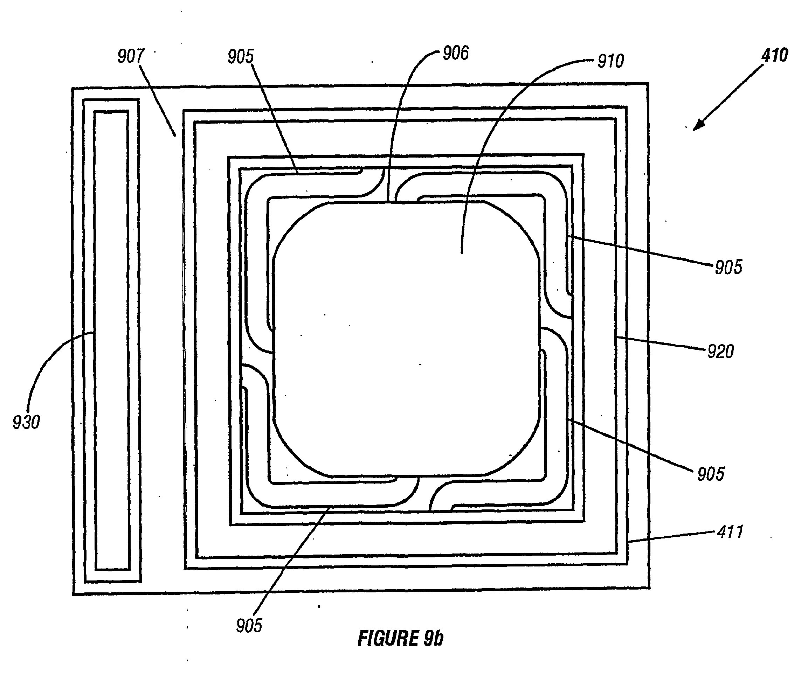

**FIG. 9b** is a top view of a top mass half of the mass wafer pair of **FIG. 9a.**

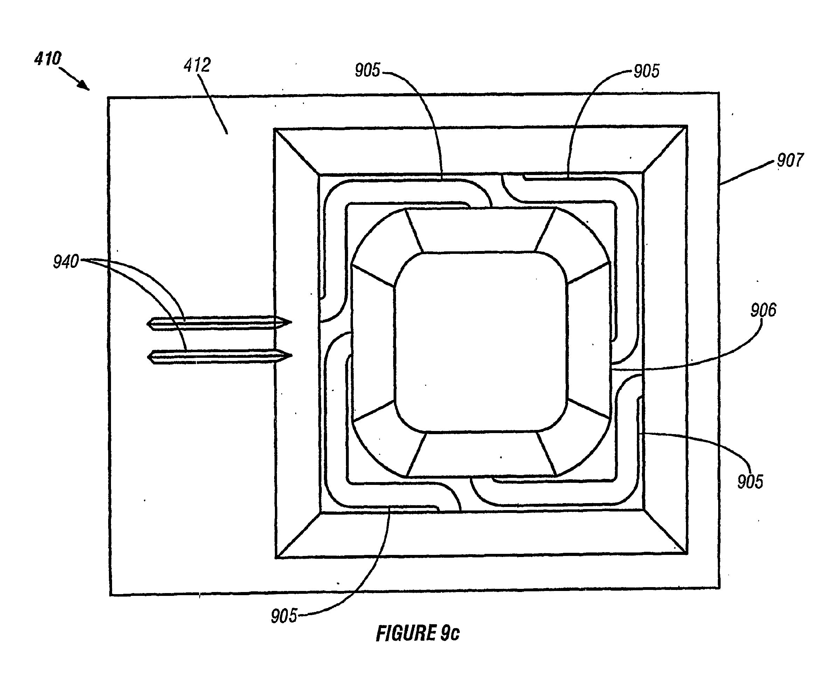

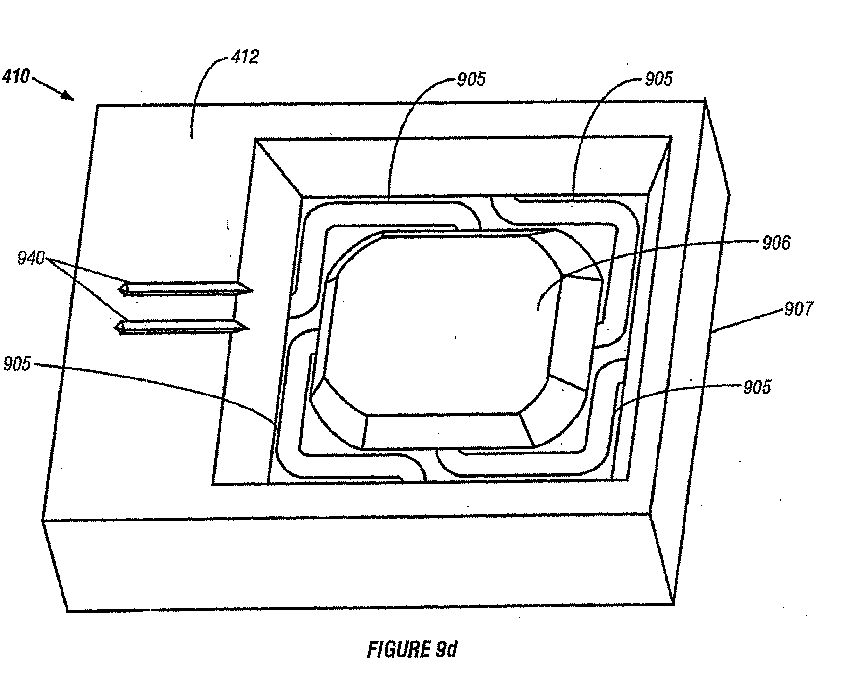

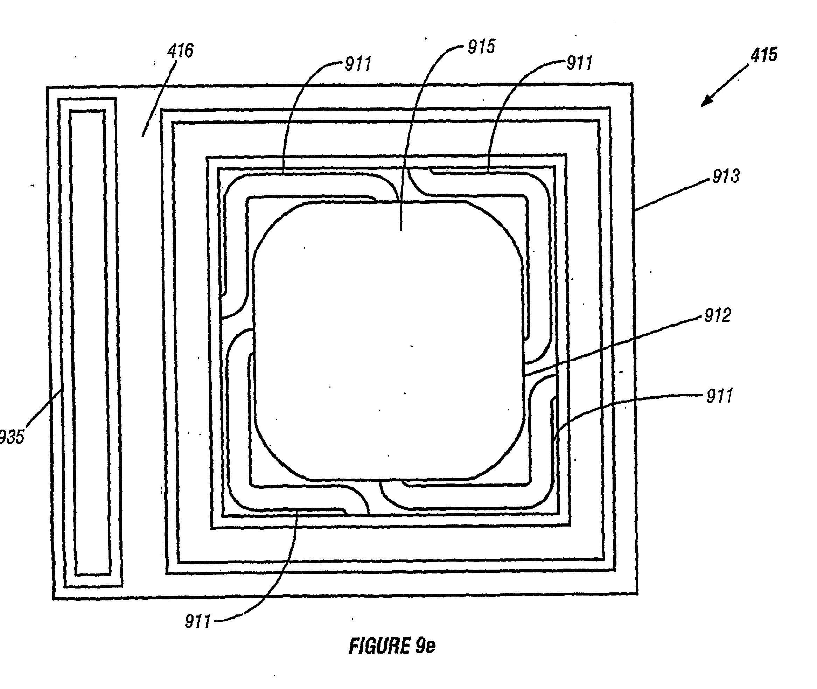

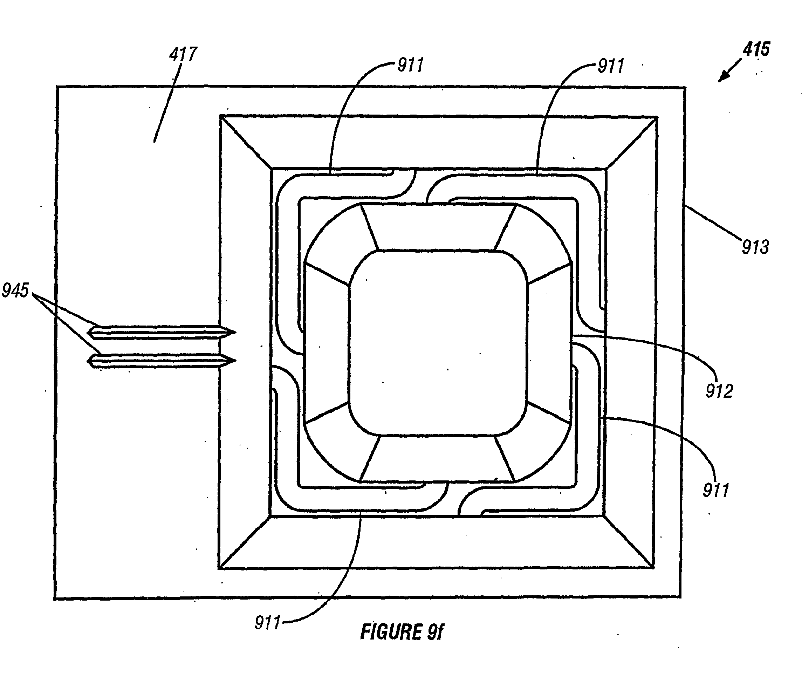

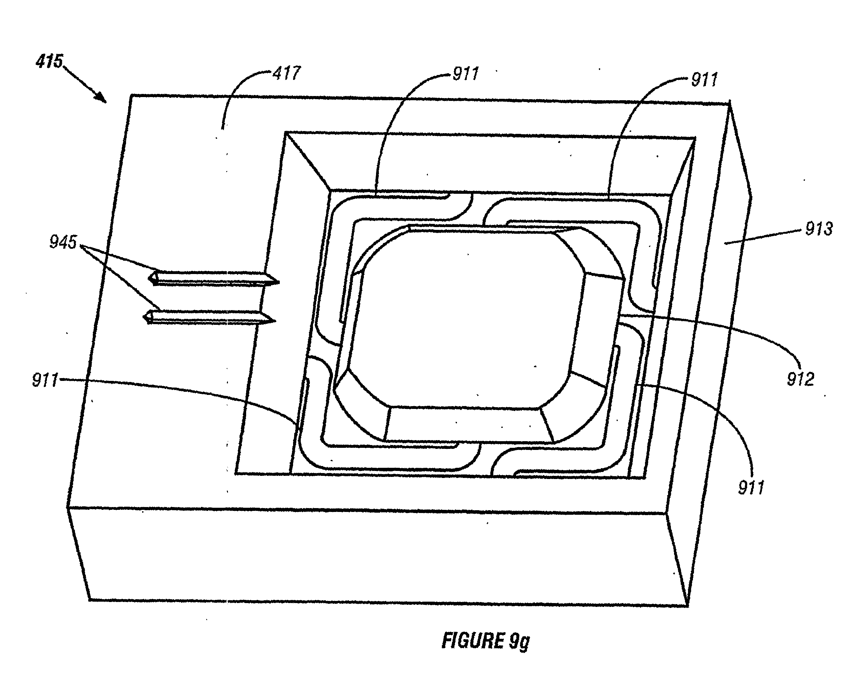

**FIG. 9c** is a bottom view of the top mass half of **FIG. 9b**.

**FIG. 9d** is a bottom perspective view of the top mass half of **FIG. 9c.**

**FIG. 9e** is a bottom view of a bottom mass half of the mass wafer pair of **FIG. 9a.**

**FIG. 9f is** a top view of the bottom mass half of **FIG. 9e.**

**FIG. 9g** is a top perspective view of the bottom mass half of **FIG. 9e.**

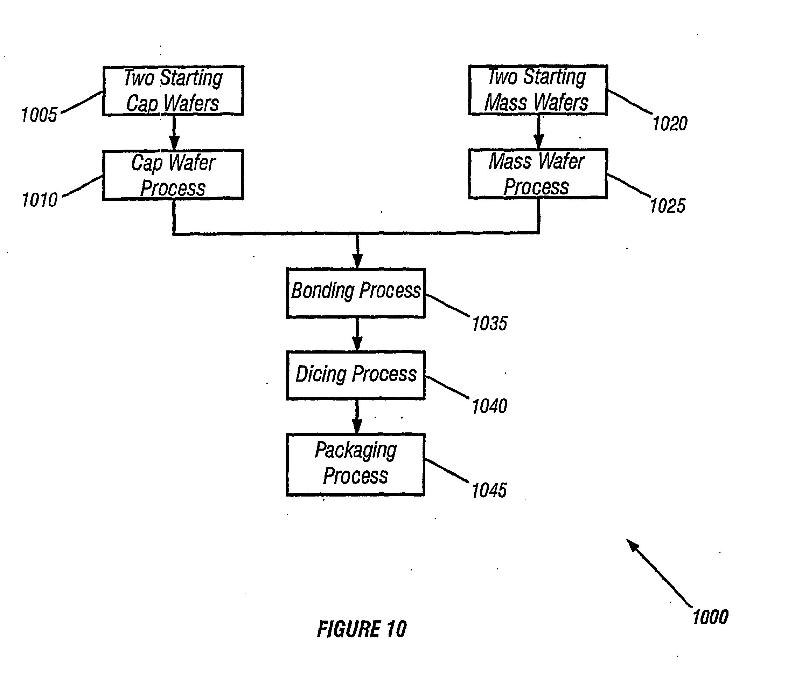

**FIG. 10** is a flowchart of a fabrication process for the accelerometer of **FIG. 4.**

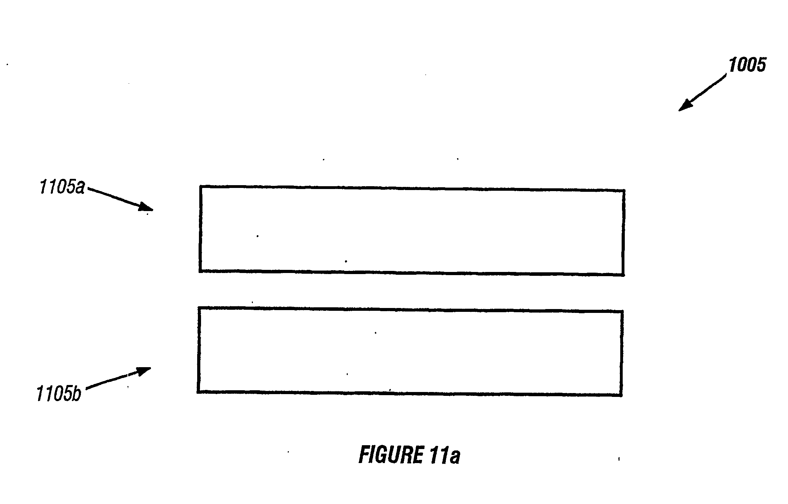

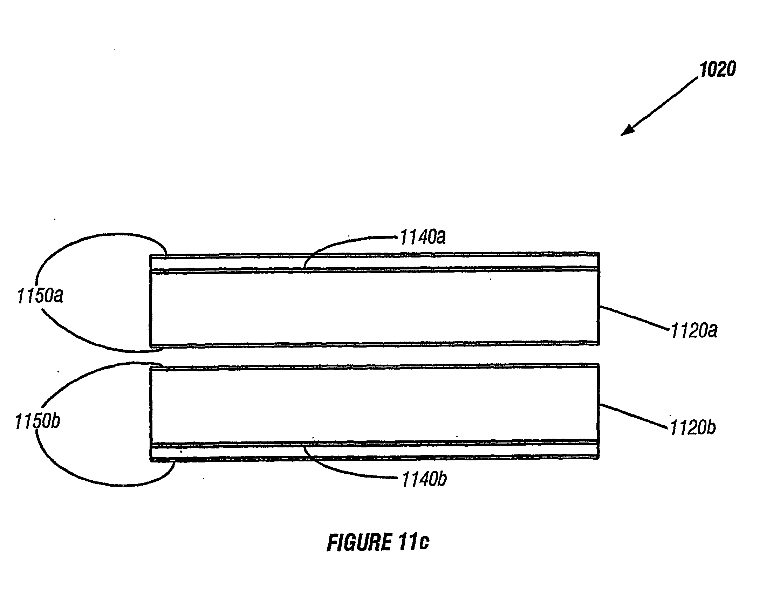

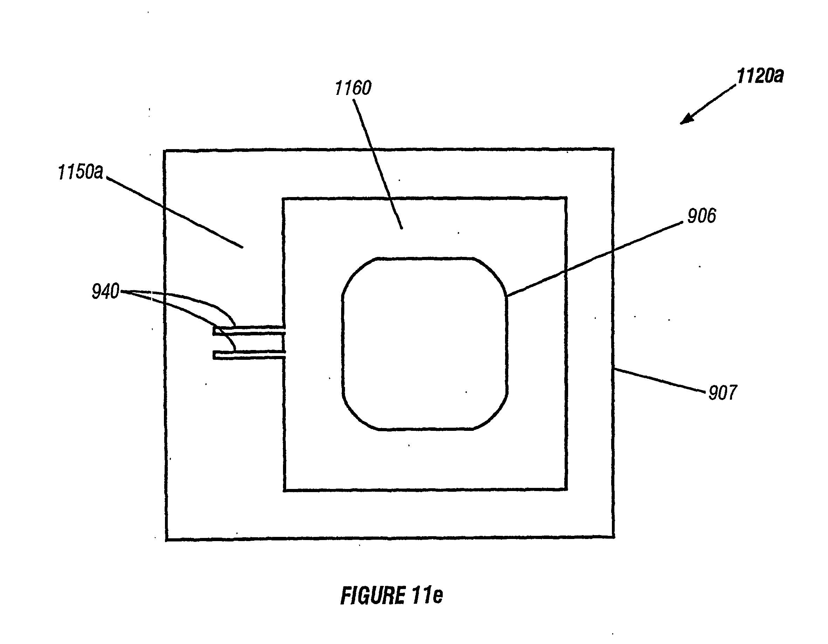

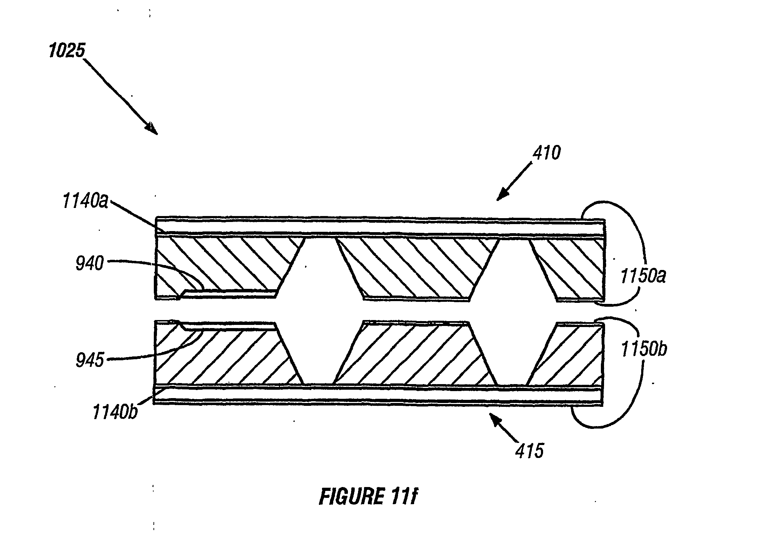

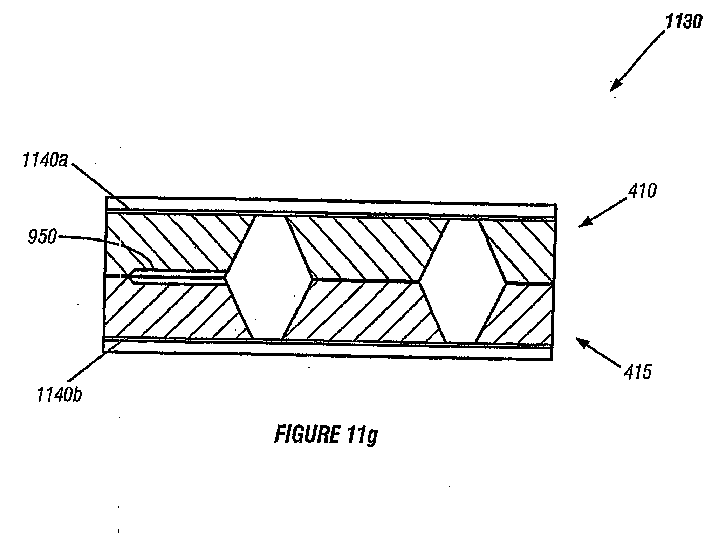

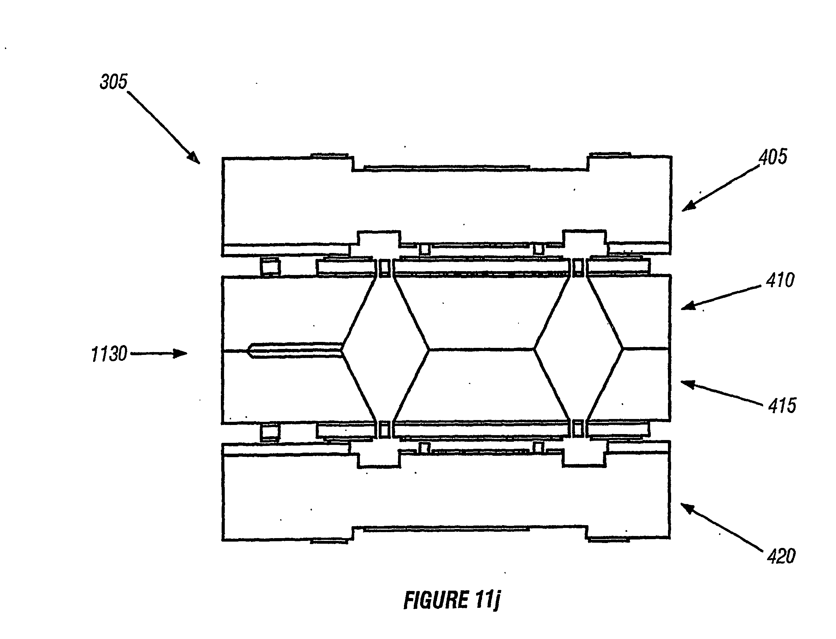

**FIG. 11a** illustrates an embodiment of the two starting cap wafers of **FIG. 10.**

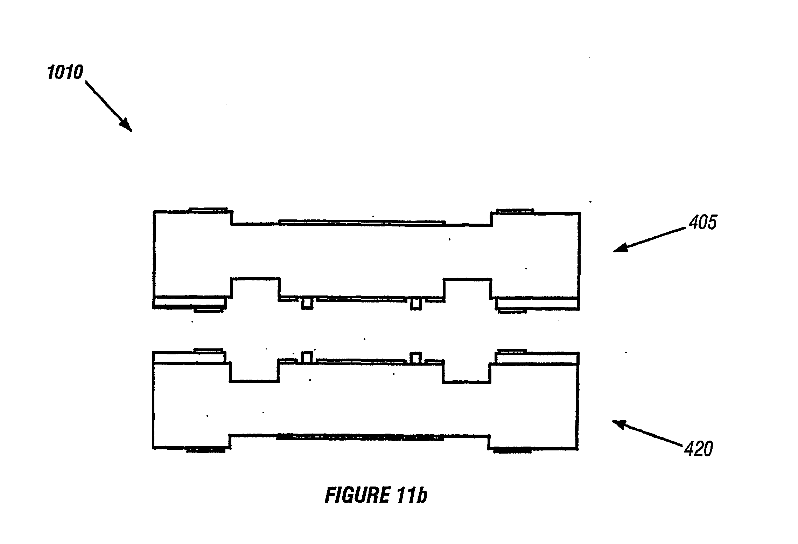

**FIG. 11b** illustrates a cross-sectional view of a top cap wafer and a bottom cap wafer resulting from the cap wafer process of **FIG. 10.**

**FIG. 11c** illustrates an embodiment of the starting mass wafers of **FIG. 10.**

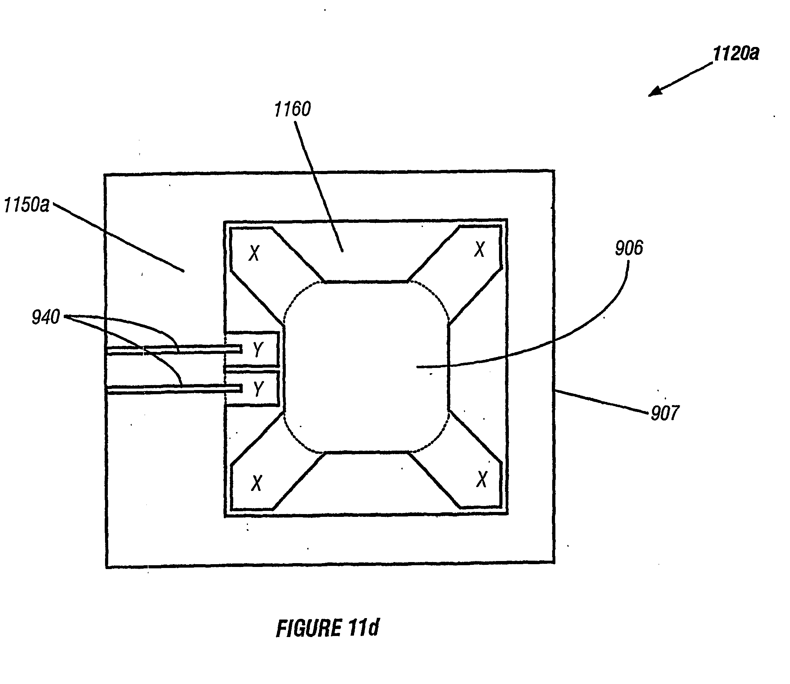

**FIG. 11d** illustrates a top view of an embodiment of a photomask outline including corner compensation structures applied to the starting mass wafers during the mass wafer process of **FIG. 10.**

**FIG. 11e** illustrates a bottom view of the top starting mass wafer after an etching phase of the mass wafer process of **FIG. 10.**

**FIG. 11f** illustrates a cross-sectional view of the top starting mass wafer and the bottom starting mass wafer after an etching phase of the mass wafer process of **FIG. 10.**

**FIG. 11g** illustrates a cross-sectional view of a bonded mass wafer pair during the mass wafer process of **FIG. 10.**

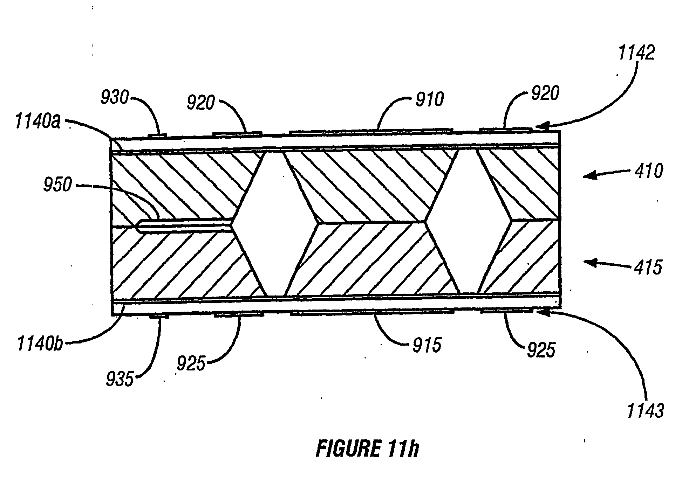

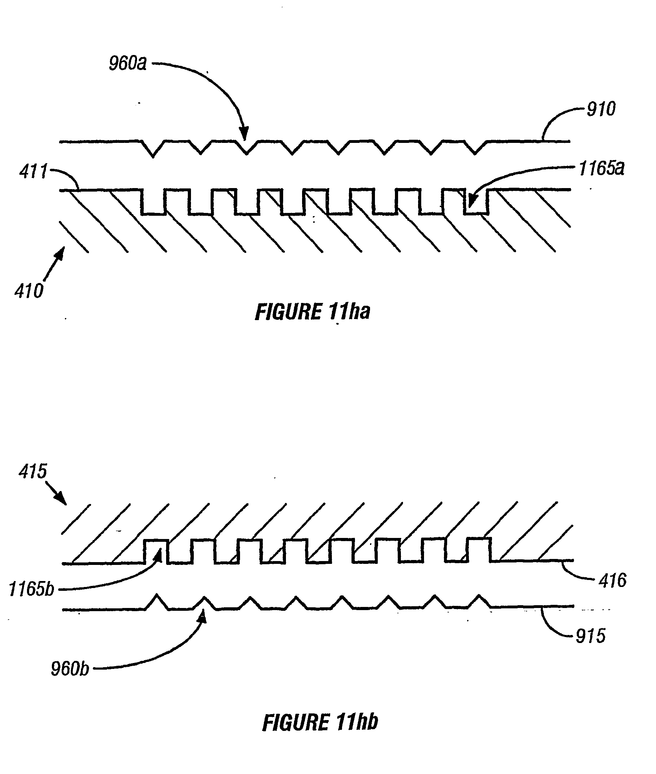

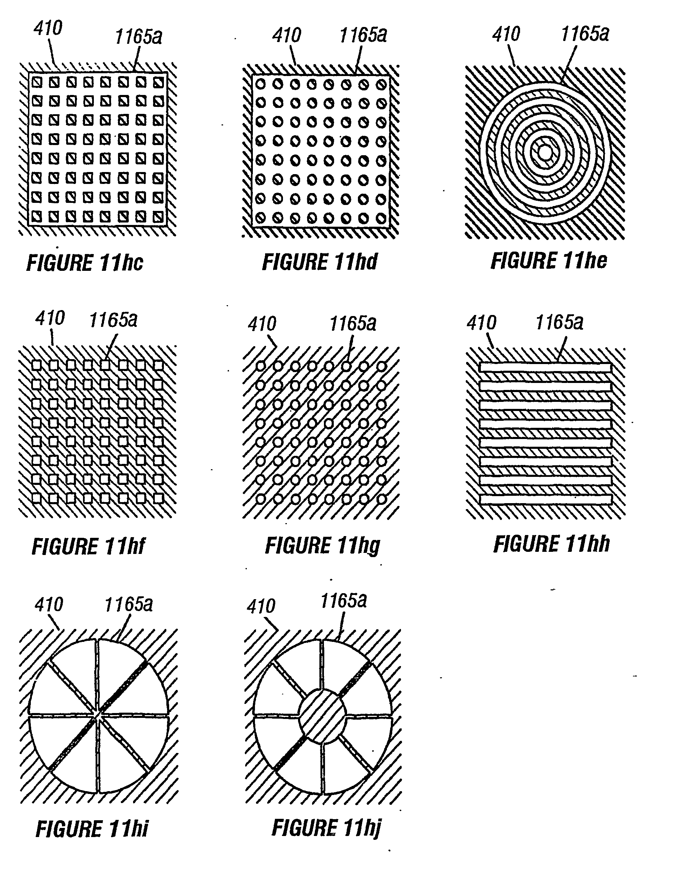

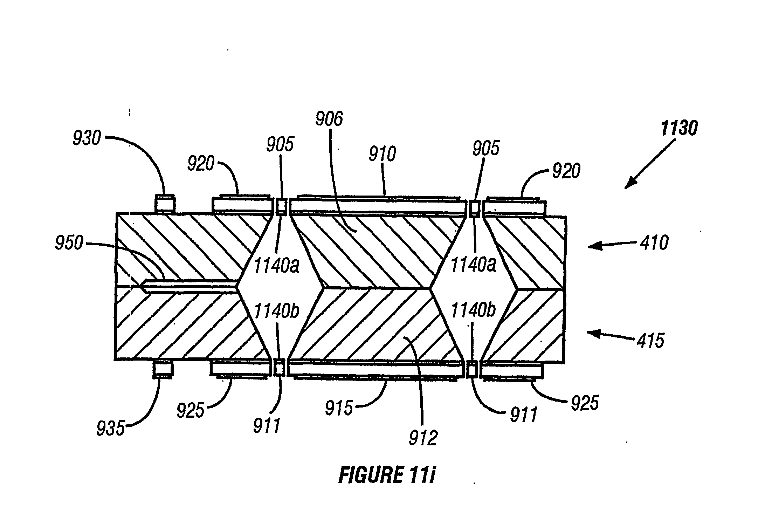

**FIG. 11h** illustrates a cross-sectional view of the bonded mass wafer pair of **FIG. 11g** including electrodes and bond rings.

FIG. **11ha** illustrates an embodiment of a metal electrode including a patterned surface on an upper surface of the mass wafer pair of **FIG. 9a.**

FIG. **11hb** illustrates an embodiment of a metal electrode including a patterned surface on a lower surface of the mass wafer pair of **FIG. 9a.**

FIG. **11hc** illustrates an embodiment of a patterned surface on the mass wafer pair of **FIG. 9a.**

FIG. **11hd** illustrates an alternative embodiment of the patterned surface of **FIG. 11hc.**

FIG. **11he** illustrates an alternative embodiment of the patterned surface of **FIG. 11hc.**

FIG. **11hf** illustrates an alternative embodiment of the patterned surface of **FIG. 11hc.**

FIG. **11hg** illustrates an alternative embodiment of the patterned surface of **FIG. 11hc.**

FIG. **11hh** illustrates an alternative embodiment of the patterned surface of **FIG. 11hc.**

FIG. **11hi** illustrates an alternative embodiment of the patterned surface of **FIG. 11hc.**

FIG. **11hj** illustrates an alternative embodiment of the patterned surface of **FIG. 11hc.**

FIG. **11i** illustrates a cross-sectional view of the bonded mass wafer pair of **FIG. 11h** including springs.

FIG. **11j** illustrates a cross-sectional view of an accelerometer after the bonding process of **FIG. 10.**

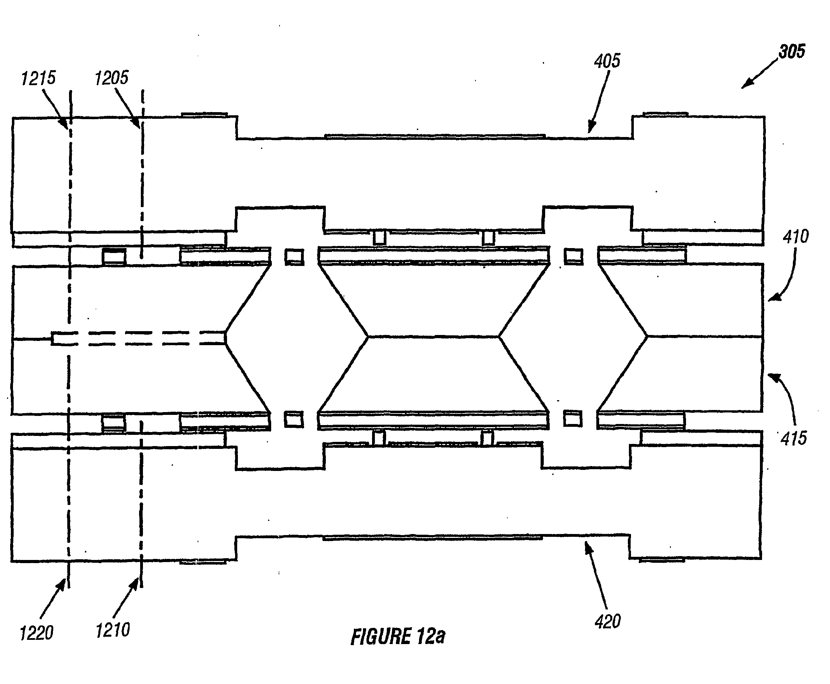

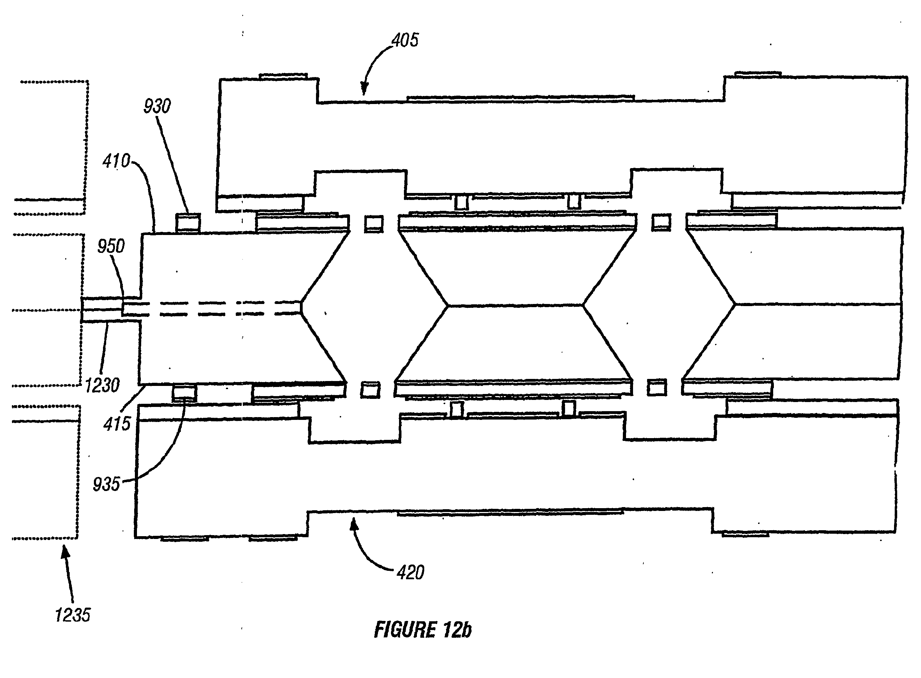

FIG. **12a** is a side view illustrating the relative positioning of dicing cuts on the accelerometer die of **FIG. 6.**

FIG. **12b** is an illustration of the accelerometer die after the dicing cuts of **FIG. 12a** have been completed.

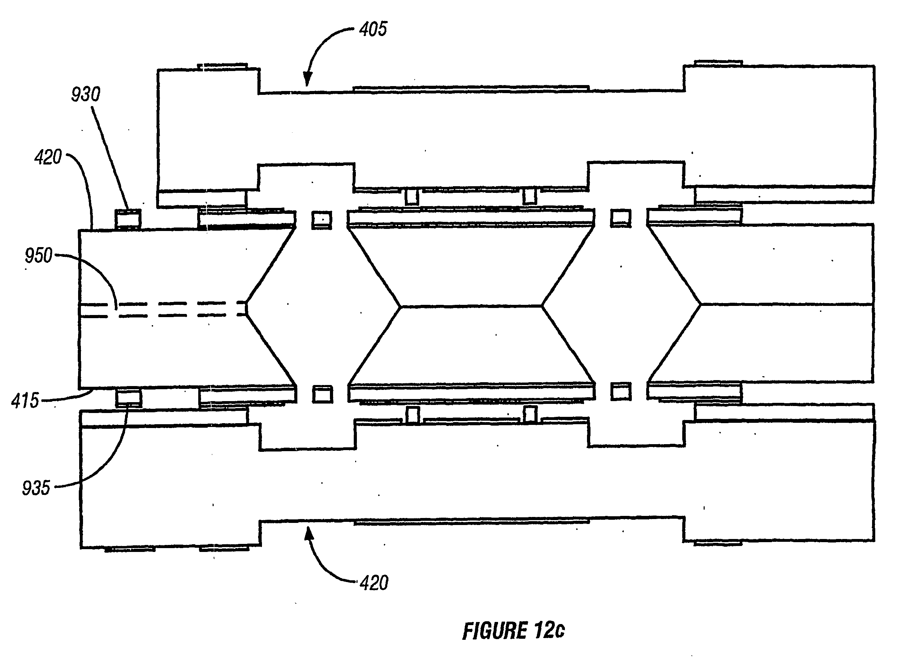

FIG. **12c** is an illustration of an embodiment of the accelerometer of **FIG. 12b** after an integrated passage has been exposed.

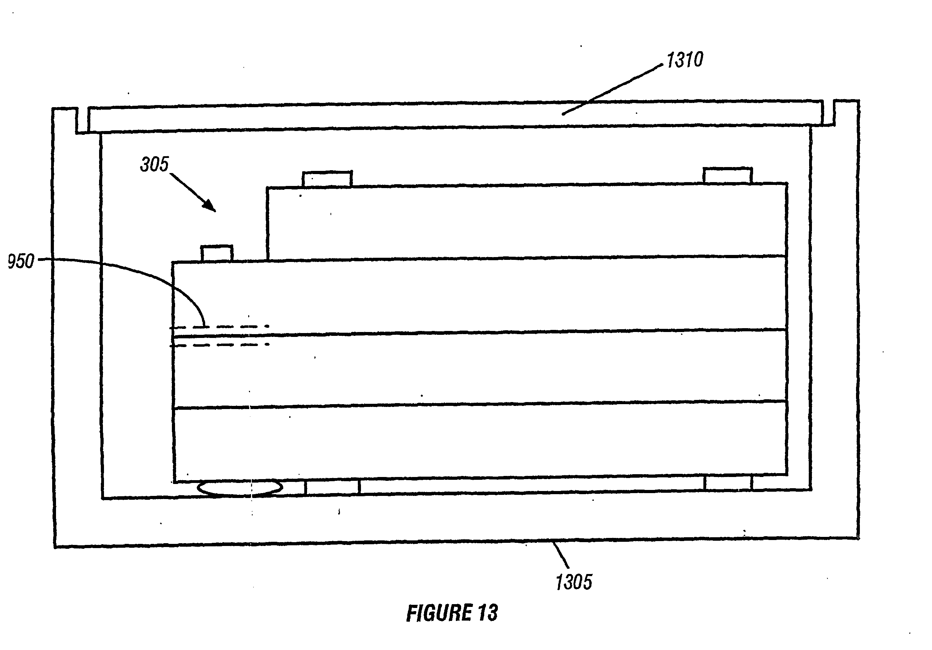

FIG. **13** is an illustration of an embodiment of the accelerometer of **FIG. 12c** packaged within a housing.

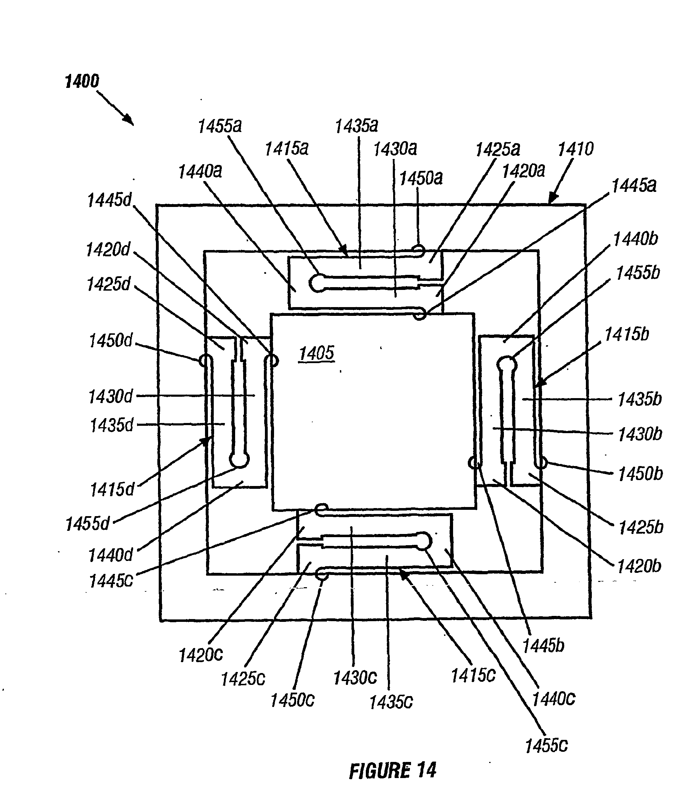

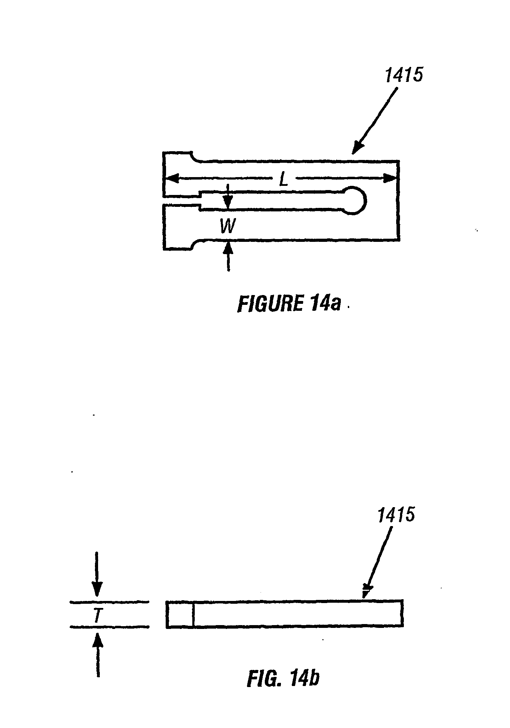

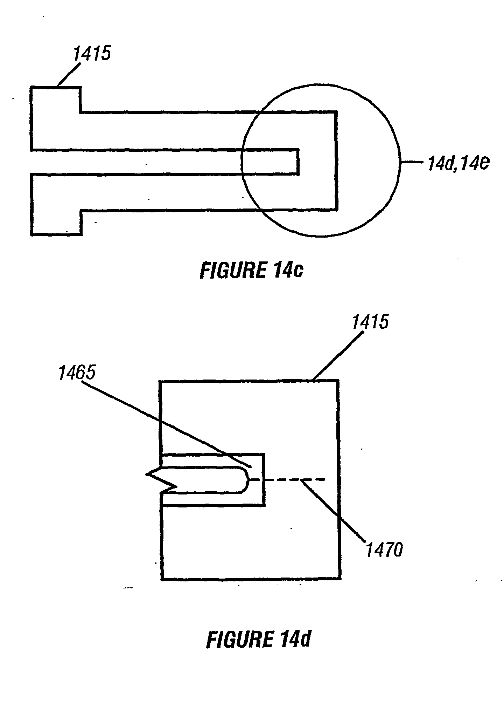

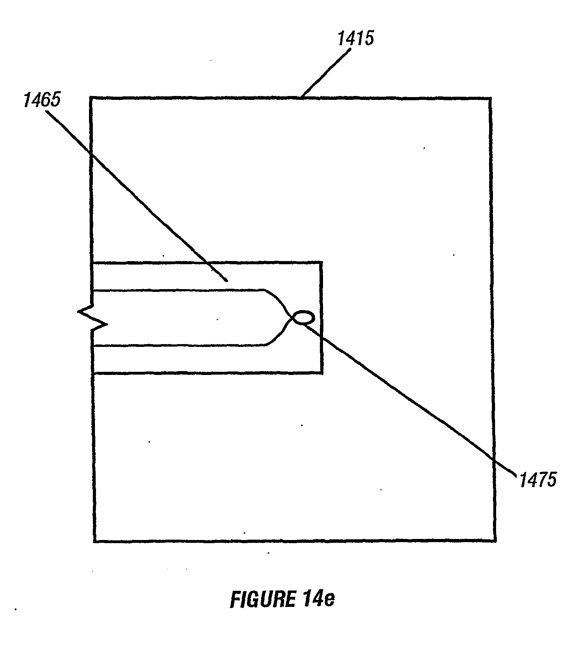

FIG. **14** is a top view of an embodiment of a mass coupled to a support structure by a number of folded beams.

FIG. **14a** is a top view of one of the folded beams of **FIG.14.**

FIG.**14b** is a side view of one of the folded beams of **FIG.14.**

FIG. **14c** is a top view of a folded beam without circular cutouts.

FIG. **14d** is an exploded top view of a portion of the folded beam of **FIG. 14c** illustrating the web artifact and the crack propagations that can be caused by the web artifact.

FIG. **14e** is an exploded top view of a portion of the folded beam of **FIG. 14c** illustrating the use of a vent hole within the web artifact in order to prevent crack propagations that can otherwise be caused by the web artifact.

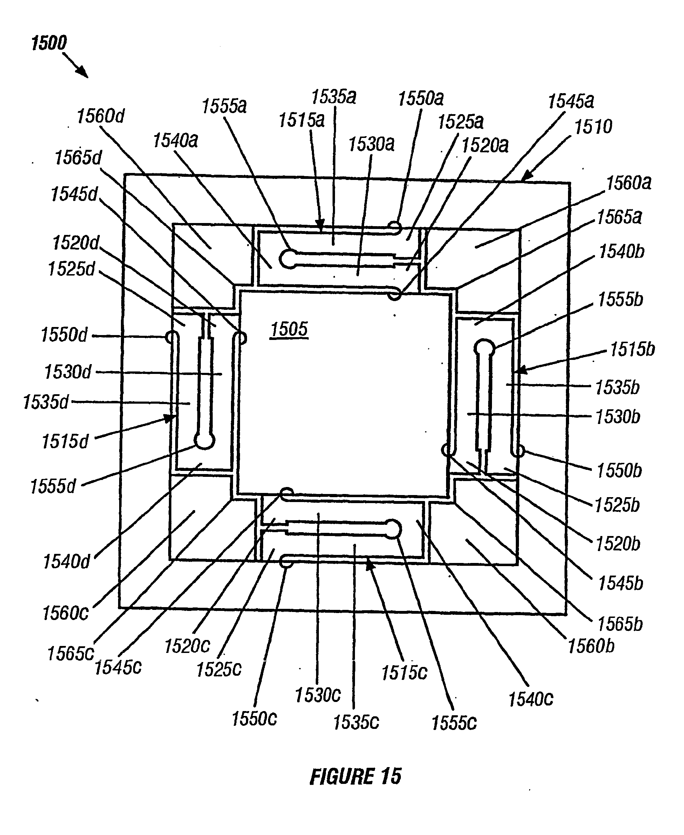

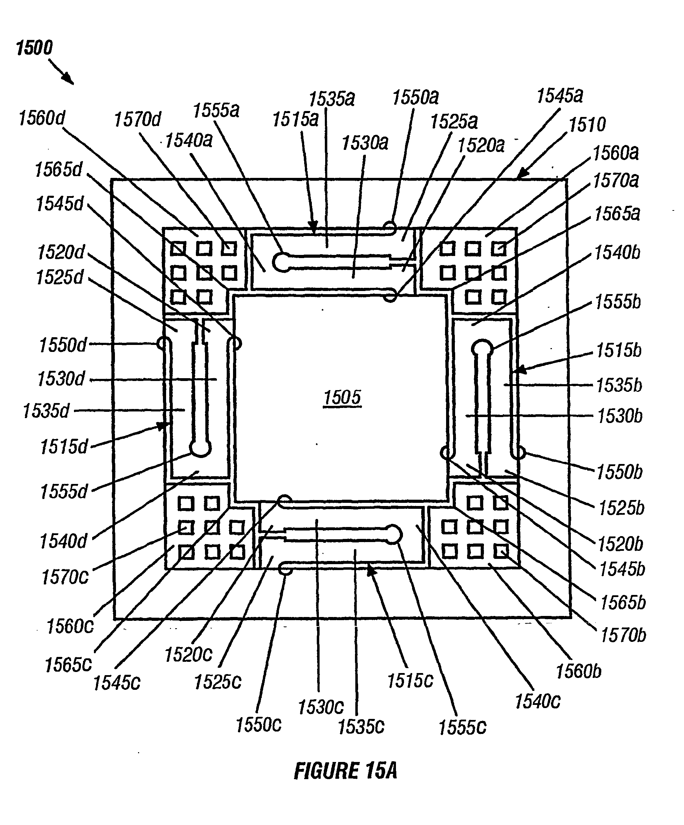

FIG. **15** is a top view of an embodiment of a mass coupled to a support structure by a number of folded beams and including a number of range-of-motion stops.

FIG. **15a** is a top view of an alternate embodiment of the assembly of **FIG. 15** including range-of-motion stops having one or more perforations for reducing fluid damping of the mass.

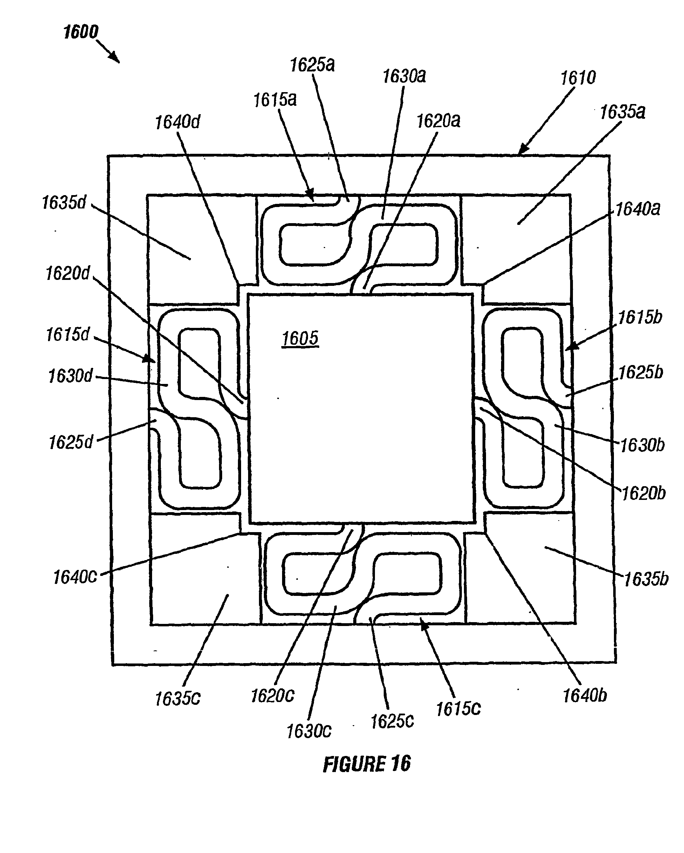

FIG. **16** is a top view of an embodiment of a mass coupled to a support structure by a number of S-shaped beams and including a number of range-of-motion stops.

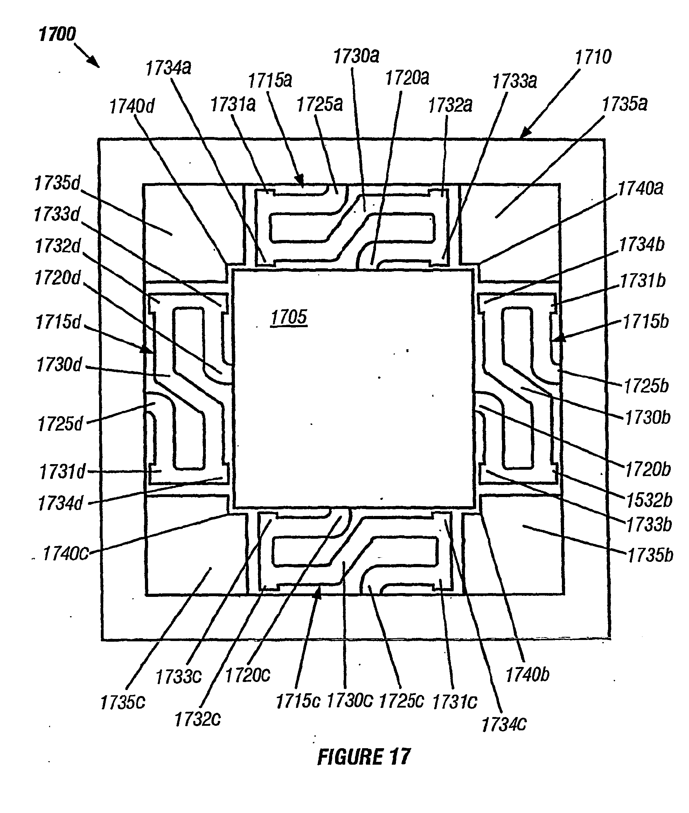

FIG. **17** is a top view of an embodiment of a mass coupled to a support structure by a number of S-shaped beams and including a number of range-of-motion stops.

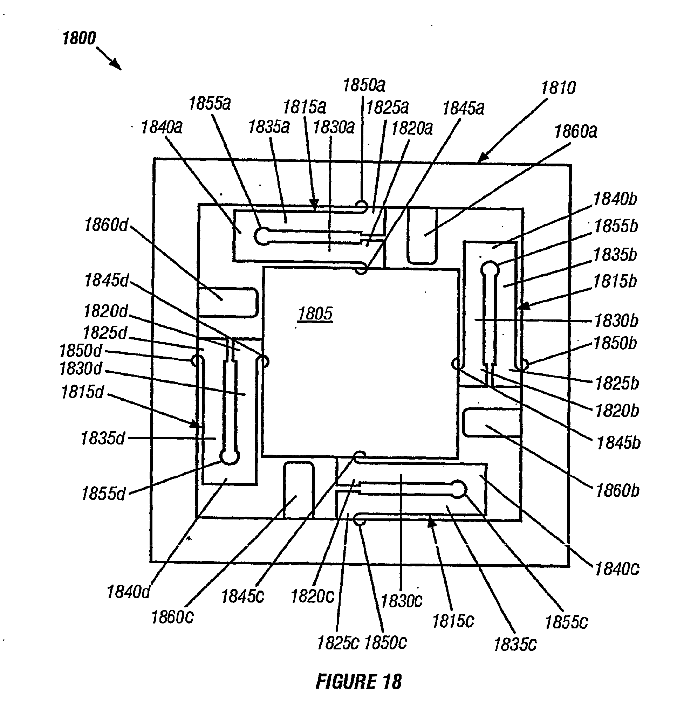

FIG. **18** is a fop view of an embodiment of a mass coupled to a support structure by a number of folded beams and including a number of range-of-motion stops.

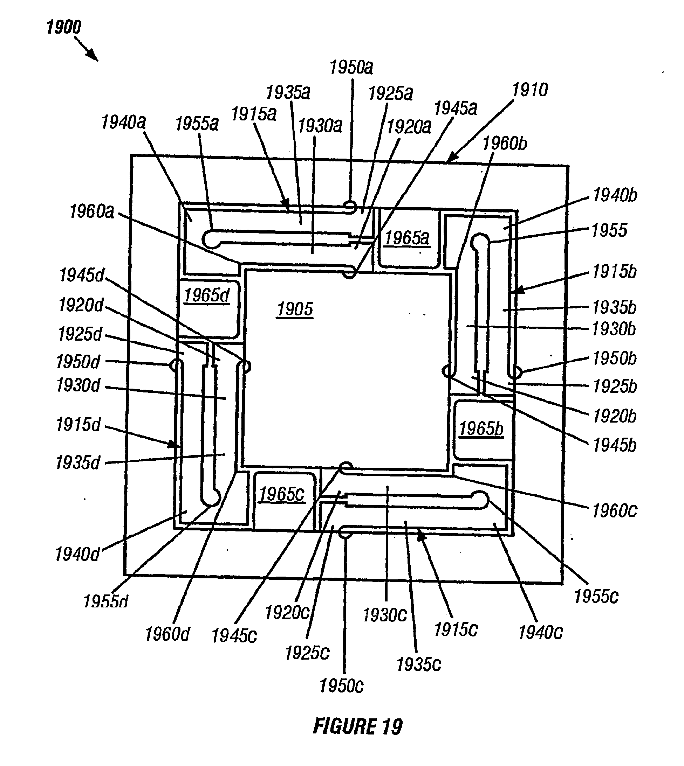

FIG. **19** is a top view of an embodiment of a mass coupled to a support structure by a number of folded beams and including a number of range-of-motion stops.

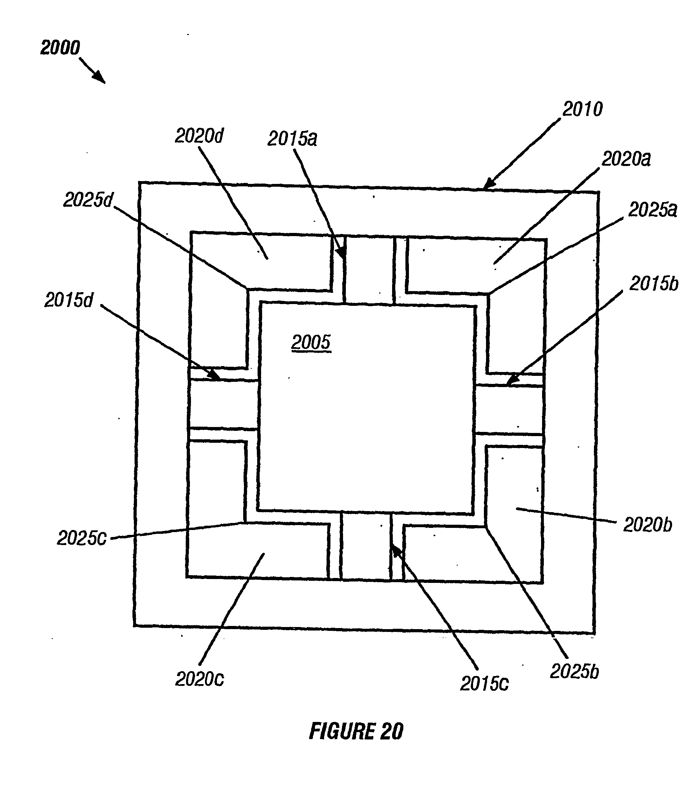

FIG. **20** is a top view of an embodiment of a mass coupled to a support structure by a number of straight beams and including a number of range-of-motion stops.

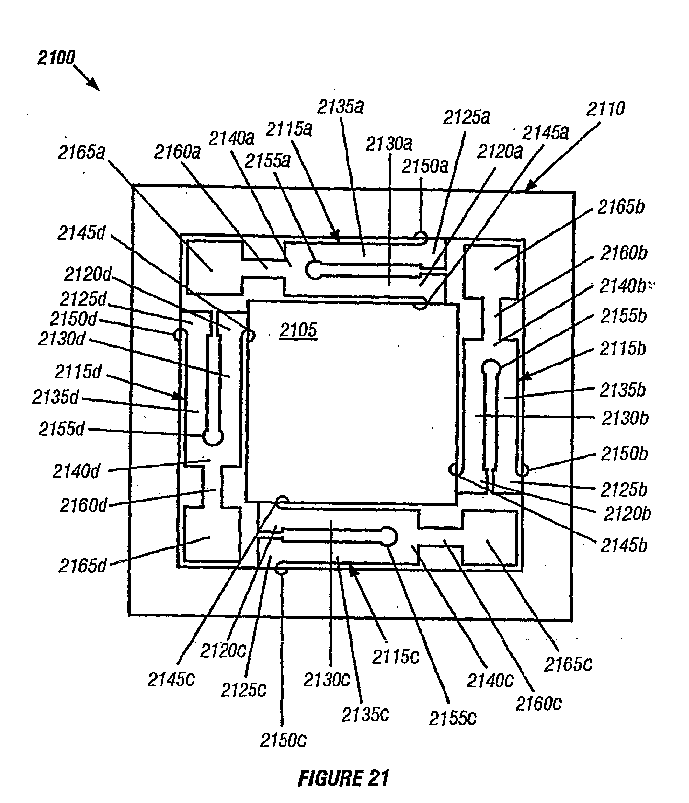

FIG. **21** is a top view of an embodiment of a mass coupled to a support structure by a number of folded beams including integral masses and including a number of range-of-motion stops.

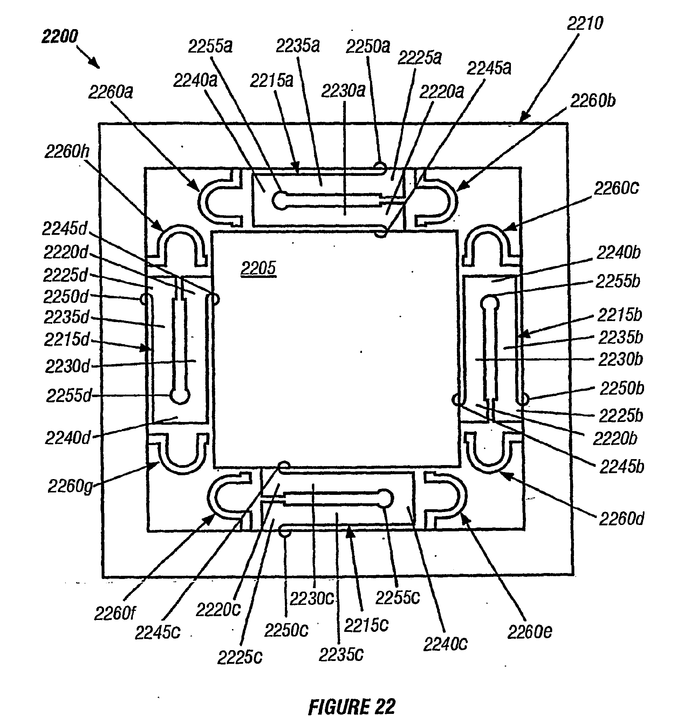

FIG. **22** is a top view of an embodiment of a mass coupled to a support structure by a number of folded beams and including a number of soft-contact range of motion stops.

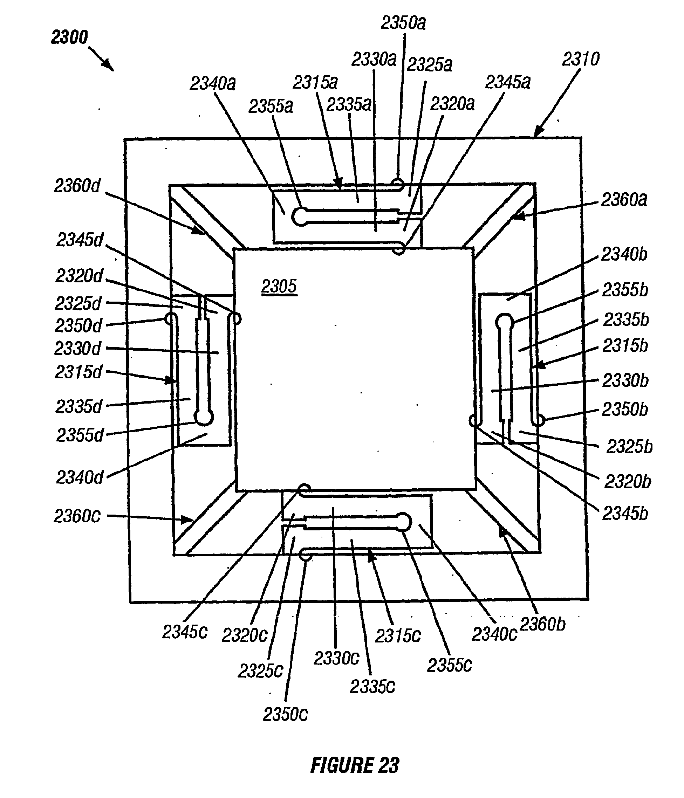

FIG. **23** is a top view of an embodiment of a mass coupled to a support structure by a number of folded beams and including a number of comer tethers.

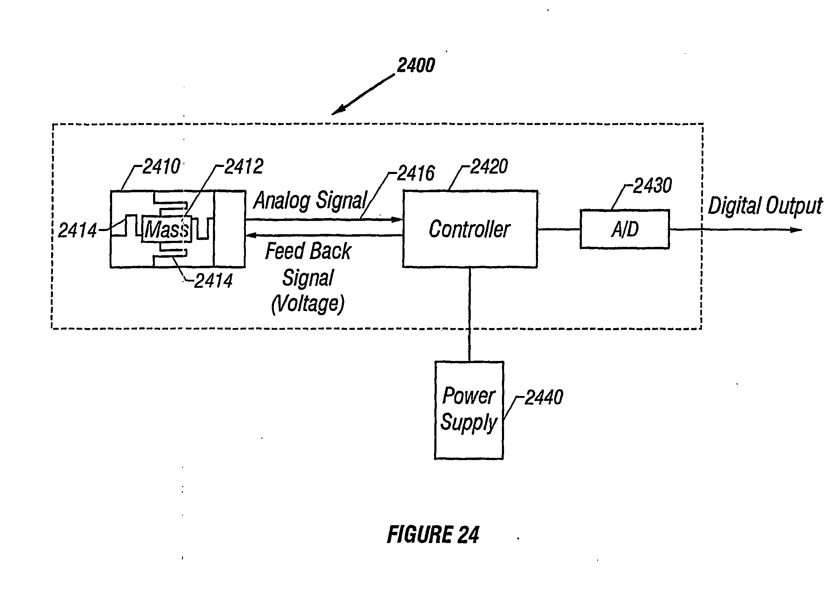

**Figure 24** shows a functional block diagram of an exemplary closed-loop system configuration using an accelerometer according to the present invention.

## Detailed Description of the Illustrative Embodiments

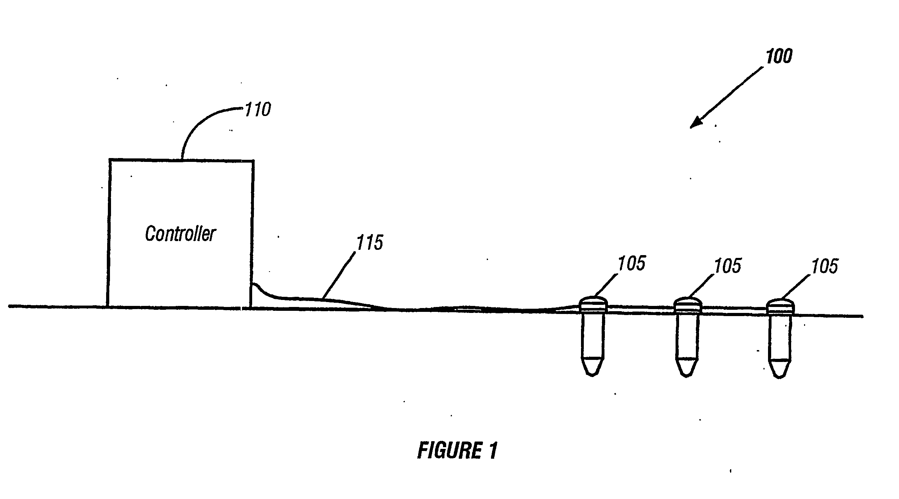

Referring initially to **FIG. 1,** a preferred embodiment of a system **100** designed to record data measurements is illustrated. The system **100** preferably includes one or more sensors **105,** a controller **110,** and cabling **115.**

Within the system **100**, the sensors **105** are used to detect data measurements. In a preferred embodiment, the system **100** is used in seismic applications to record seismic data measurements. The sensors **105** may be any number of conventional commercially available sensors, such as, for example, a geophone, a hydrophone, or an accelerometer. In a preferred embodiment, each of the sensors **105** is an accelerometer.

The controller **110** is used to monitor and control the sensors **105**. The controller **110** is preferably coupled to the sensors **105** by the cabling **115**. The controller **110** may be any number of conventional commercially available controllers suitable for controlling the sensors **105,** such as, for example, a seismic data acquisition device, a PID controller, or a microcontroller. In a preferred embodiment, the controller **110** is a seismic data acquisition device.

The cabling **115** couples the sensors **105** and the controller **110**. The cabling **115** may be any cabling suitable for transmitting information between the sensors **105** and controller **110,** such as, for example, wire or fiber optics. In a preferred embodiment, the cabling **115** is a wire.

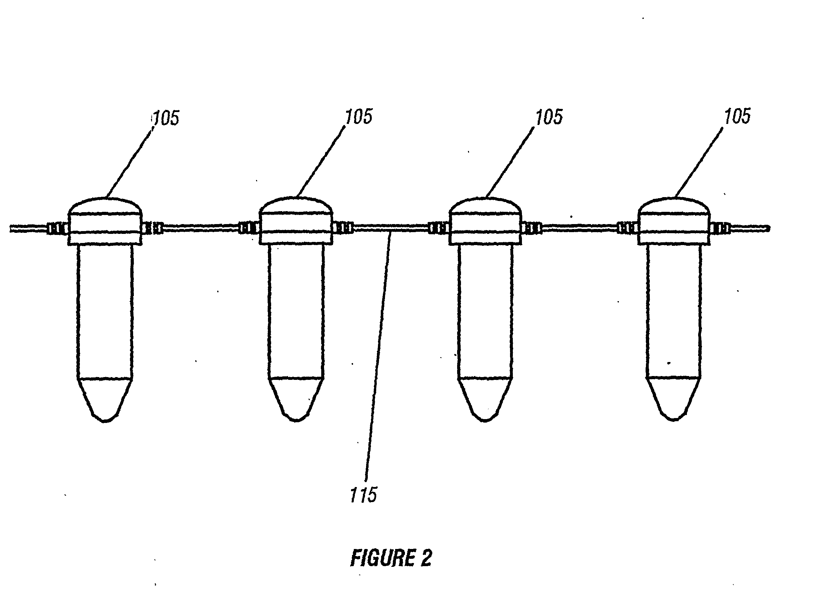

Referring to **FIG. 2**, a preferred embodiment of the alignment of the sensors **105** and the cabling **115** within the system **100** is illustrated. The sensors **105** and the cabling **115** may be aligned linearly or non-linearly. In a preferred embodiment, the sensors **105** and cabling **115** are aligned linearly.

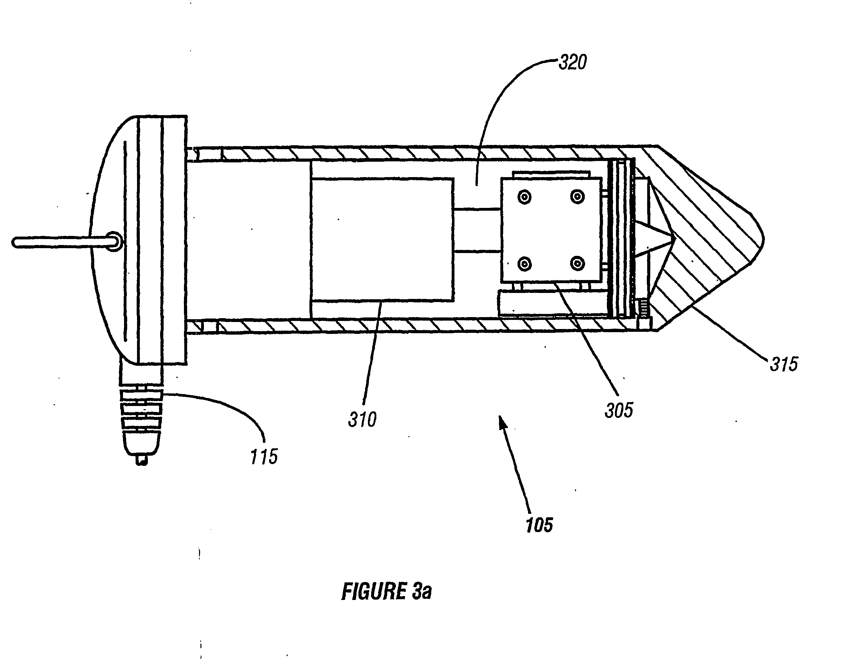

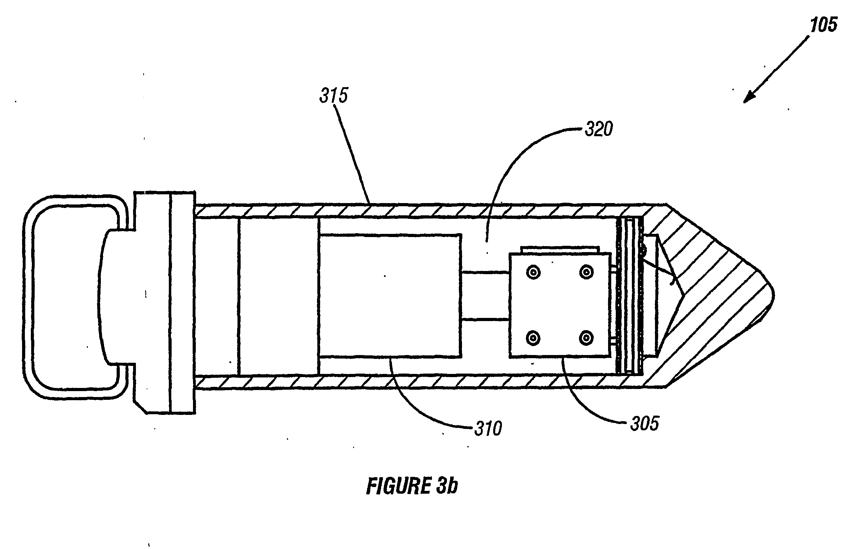

The sensors **105** may include any number of conventional commercially available components suitable for creating a sensor. Referring to **FIGS. 3a** and **3b**, in a preferred embodiment, the sensors **105** include one or more accelerometers **305**, and a housing **315** having a cavity **320**. In another preferred embodiment, the sensors **105** further include a measurement device **310**. In a preferred embodiment, the sensors **105** each include three accelerometers **305**. The accelerometers **305** are preferably placed in the cavity **320** within the housing **315** of the sensor **105**. The accelerometers **305** may be coupled to the measurement device **310**, or may operate independently within the sensor **105**. In a preferred embodiment, the accelerometers **305** operate independently within the sensor **105**. The measurement device **310** may be any number of conventional commercially available devices suitable for coupling with the accelerometer **305** to create a sensor **105**, such as, for example, a geophone or a hydrophone. In a preferred embodiment, the measurement device **310** is a hydrophone.

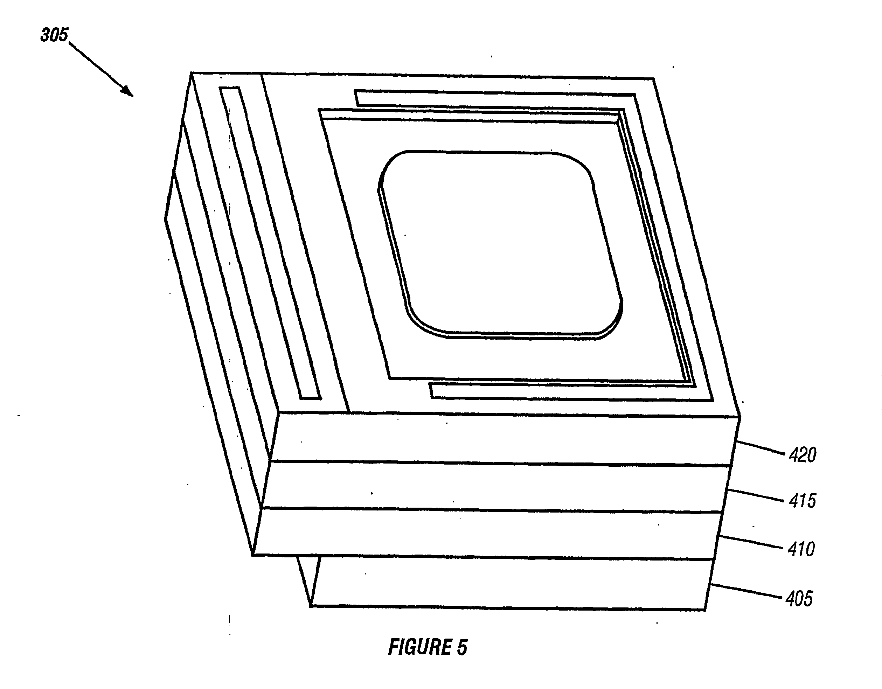

The accelerometer **305** may include any number of components suitable for forming an accelerometer. Referring to **FIGS. 4, 5,** and **6**, in a preferred embodiment, the accelerometer **305** includes a top cap wafer **405**, a top measurement mass half **410**, a bottom measurement mass half **415,** and a bottom cap wafer **420.** The operation of the accelerometer **305** is preferably provided substantially as described in U.S. Pat. No. 5,852,242, U.S. Pat. No. 6,035,694, and PCT patent application serial number PCT/US00/40038, filed on March 16, 2000, the disclosures of which is incorporated herein by reference.

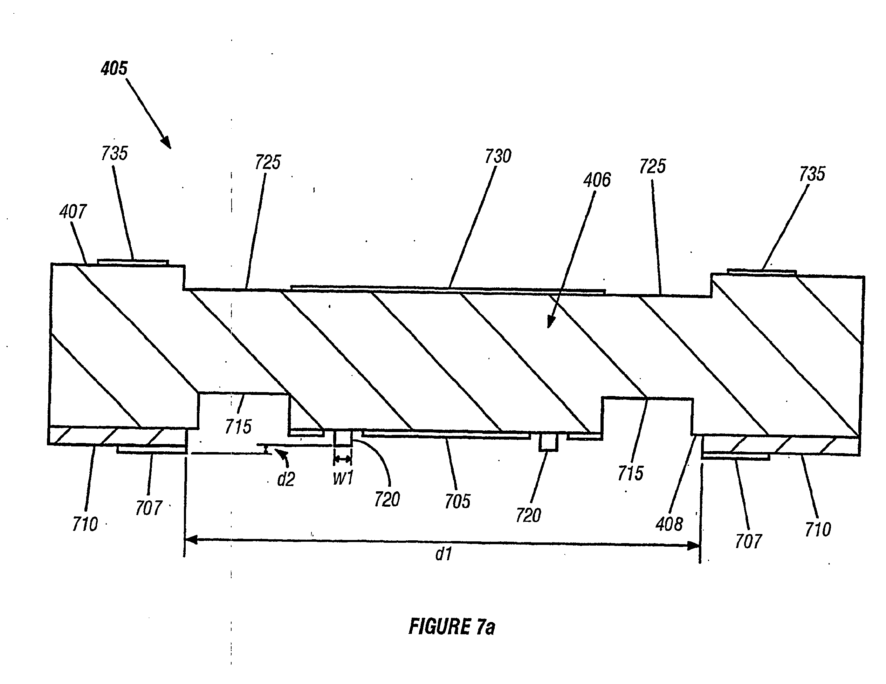

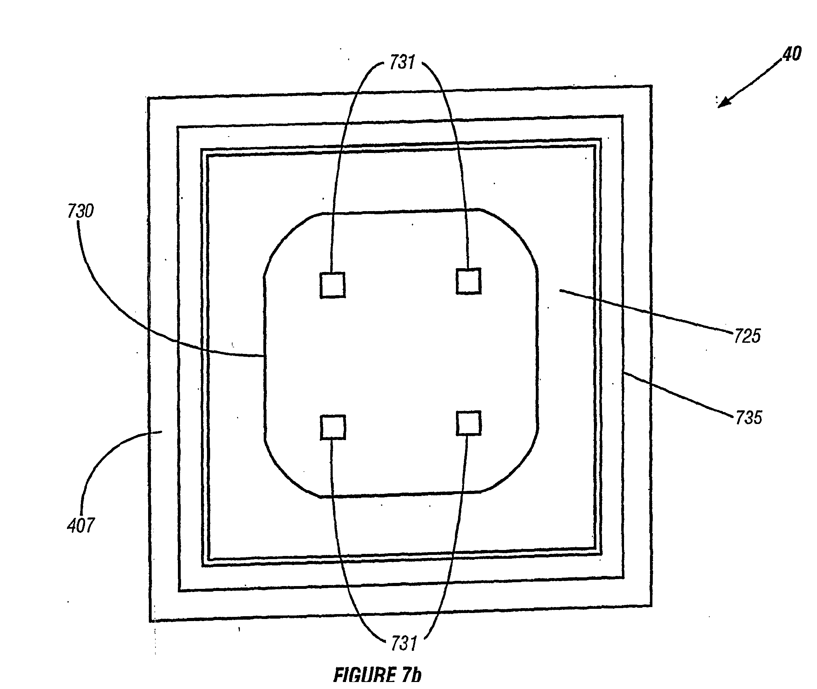

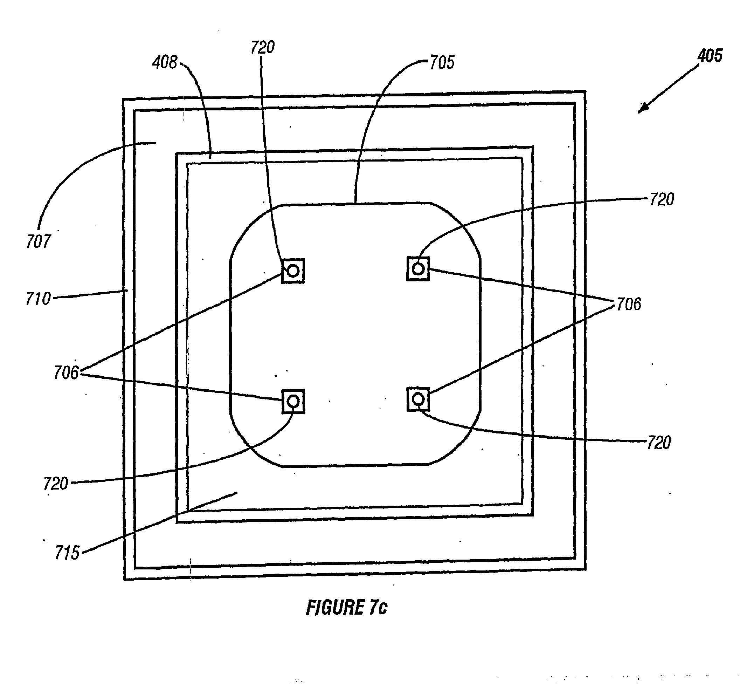

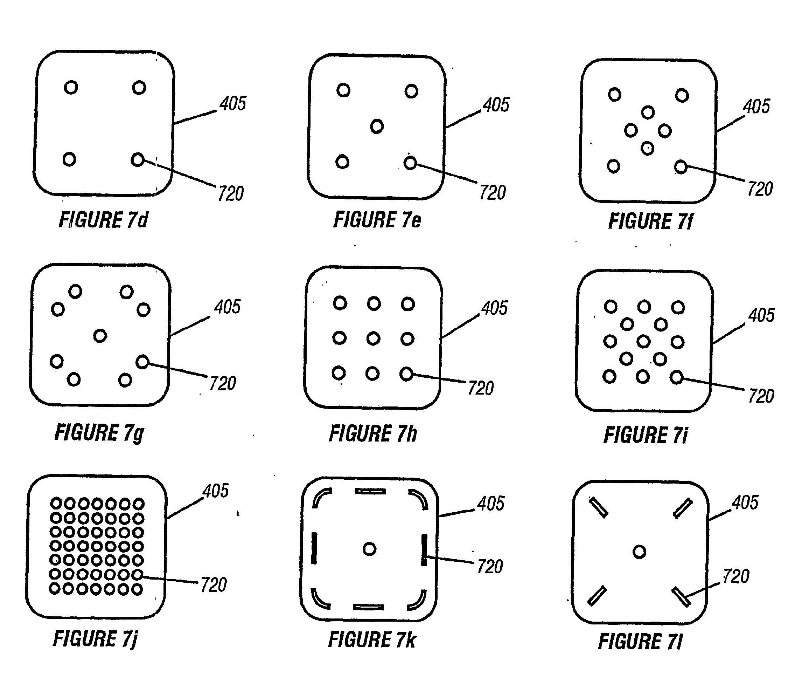

The top cap wafer **405** may include any number of conventional commercially available components suitable for forming a top cap wafer. In a preferred embodiment, as illustrated in **FIGS. 7a, 7b, 7c, 7d, 7e, 7f, 7g, 7h, 7i, 7j, 7k, and 7l,** the top cap wafer **405** includes a top cap wafer body **406**, an upper surface **407**, a bottom surface **408**, a top capacitor electrode **705**, a top bond ring **707**, a top bond oxide ring **710**, a top cap parasitic groove **715**, top cap overshock bumpers **720**, a top cap press frame recess **725**, a top cap balanced metal pattern **730**, and a top cap contact pad **735**.

The top cap wafer body **406** may be fabricated from any number of conventional commercially available materials suitable for creating a cap wafer body, such as, for example, glass, quartz, ceramic, or silicon. In a preferred embodiment, the top cap wafer body 406 is made of silicon.

The top capacitor electrode **705** is preferably used for the time-based multiplexing of electrical signals from an external circuit, the operation of which is substantially as described in PCT patent application serial number PCT/US00/40038. The top capacitor electrode **705** is preferably located on the bottom surface **408** of the top cap wafer body **406,** within an area circumscribed by the top cap parasitic groove **715**. In a preferred embodiment, as illustrated in **FIG. 7c,** the top capacitor electrode **705** includes slots **706** into which the top cap overshock bumpers **720** are fabricated. The top capacitor electrode **705** may be fabricated from any number of conductive materials suitable for creating an electrode, such as, for example, metals, silicides, or doped semiconductors. In a preferred embodiment, the top capacitor electrode **705** is fabricated from a combination of gold and titanium. In a preferred embodiment, the combination of gold and titanium includes a layer of gold located on top of a layer of titanium. The layer of titanium preferably improves the adhesion of the gold to silicon and silicon dioxide.

The top bond ring **707** and the top bond oxide ring **710** preferably bond the top cap wafer **405** to the top measurement mass half **410** and help establish a narrow gap between the top capacitor electrode **705** and an electrode located on an upper surface of the top measurement mass half **410.** The top bond oxide ring **710** preferably provides electrical isolation between the top cap wafer **405** and the top measurement mass half **410.** The top bond ring **707** and the top bond oxide ring **710** are preferably located on the bottom surface **408** of the top cap wafer body **406.** The top bond ring **707** may be fabricated from any number of materials suitable for making a bond ring, such as, for example, gold, silver, or aluminum. In a preferred embodiment, the top bond ring **707** is fabricated from a combination of gold and titanium. In a preferred embodiment, the combination of gold and titanium includes a layer of gold located on top of a layer of titanium. The layer of titanium preferably improves the adhesion of the gold to silicon and silicon dioxide. The bond ring **707** may have any dimensions suitable for use within the accelerometer **305**. In a preferred embodiment, as illustrated in **FIG. 7a**, the bond ring **707** has a width d1 that is smaller than the width of the top cap press frame recess **725**. In a preferred embodiment, the bond ring **707** extends below the top cap overshock bumpers **720** by a distance d2. The top bond oxide ring **710** may be fabricated from any number of conventional commercially available materials suitable for making a bond oxide ring, such as, for example, silicon dioxide or dielectrics. In a preferred embodiment, the top bond oxide ring **710** is fabricated from silicon dioxide.

The top cap parasitic groove **715** preferably minimizes the coupling of electrostatic feedback of an external close-loop circuit to springs included in the top measurement mass half **410**. The top cap parasitic groove **715** preferably is a groove within the bottom surface 408 of the top cap wafer body **406**. The top cap parasitic groove **715** preferably circumscribes the top capacitor electrode **705** and is surrounded by the top bond oxide ring **710**. The top cap parasitic groove **715** may include any dimensions suitable for creating an adequate parasitic groove. In a preferred embodiment, the top cap parasitic groove **715** measures greater than about 5 microns in depth and has a width wider than the width of the springs within the top measurement mass half **410.**

The top cap overshock bumpers **720** preferably provide out-of-plane shock protection to the top measurement mass half **410**. The top cap overshock bumpers **720** are preferably located on the bottom surface **408** of the top cap wafer body **406,** and are exposed through the cutouts **706** in the top capacitor electrode **705**. The top cap overshock bumpers **720** may be fabricated from any number of conventional commercially available materials suitable for creating overshock bumpers, such as, for example, silicon dioxide or dielectrics. In a preferred embodiment, the top cap overshock bumpers **720** are made of silicon dioxide. In a preferred embodiment, as illustrated in **FIG. 7a,** the top cap overshock bumpers **720** have a width w1. The top cap wafer **405** may include any number of top cap overshock bumpers **720**. The design and layout of the top cap overshock bumpers **720** may be affected by any number of factors. In a preferred embodiment, the design and layout of the top cap overshock bumpers **720** balances the need for shock protection with the need for minimal stiction between the top cap overshock bumpers **720** and a metal electrode pattern **910** located on the top measurement mass half **410**. Stiction occurs when the top cap overshock bumpers **720** stick to the metal electrode pattern **910** on the top measurement mass half **410** during the operation of the accelerometer **305**. The stiction between the top cap overshock bumpers **720** and the metal electrode pattern located on the top measurement mass half **410** may be caused by any number of sources, such as, for example, imprinting of the top cap overshock bumpers **720** onto the metal electrode pattern **910** located on the top measurement mass half **410**, Van Der Waals forces, electrostatic forces, surface residues resulting from the fabrication of the accelerometer **305,** or package-induced stresses. In a preferred embodiment, as illustrated in **FIG. 7d,** the top cap wafer **405** includes four bumpers. In an alternative embodiment, as illustrated in **FIG. 7e**, the top cap wafer **405** includes five top cap overshock bumpers **720**. In an alternative embodiment, as illustrated in **FIG. 7f,** the top cap wafer **405** includes eight geometrically arranged top cap overshock bumpers **720**. In an alternative embodiment, as illustrated in **FIG. 7g,** the top cap wafer **405** includes nine geometrically arranged top cap overshock bumpers **720.** In an alternative embodiment, as illustrated in **FIG. 7h**, the top cap wafer **405** includes nine top cap overshock bumpers **720** arranged in three linear, parallel rows with each row having three bumpers **720**. In an alternative embodiment, as illustrated in **FIG. 7i**, the top cap wafer **405** includes thirteen geometrically arranged top cap overshock bumpers **720**. In an alternative embodiment, as illustrated in **FIG. 7j,** the top cap wafer **405** includes forty nine top cap overshock bumpers **720**. In an alternative embodiment, as illustrated in **FIGS. 7k and 7l,** the top cap wafer **405** includes a plurality of geometrically arranged top cap overshock bumpers **720** in the shape of circles and ridges.

The top cap press frame recess **725** is preferably located on the upper surface **407** of the top cap wafer body **406** between the top cap balanced metal pattern **730** and the top cap contact pad **735.** The top cap press frame recess **725** preferably ensures that bond forces as applied during a bonding process are localized to the top bond oxide ring **710** region. By localizing bond forces to the top bond oxide ring **710** region rather than to the region of the narrow gap between the top capacitor electrode **705** and the electrode located on an upper surface of the top measurement mass half **410**, the narrow gap between the electrodes is maintained. The top cap press frame recess **725** may be formed using any number of processing steps suitable for forming a press frame recess such as, for example, silicon etching. In a preferred embodiment, the top cap press frame recess **725** is etched into the upper surface **407** of the top cap wafer body **406.** The top cap press frame recess **725** may include any dimensions suitable for creating a press frame recess. In a preferred embodiment, the top cap press frame recess **725** measures greater than about 20 microns in depth, and has a width wider than the width **d1** of the bond ring **707**.

The top cap contact pad **735** is preferably located on the upper surface **407** of the top cap wafer body **406**. The top cap contact pad **735** is preferably available for wire bonding. The top cap contact pad **735** may include any number of conventional commercially available materials suitable for creating a contact pad such as, for example, gold, aluminum, or silver. In a preferred embodiment, the top cap contact pad **735** is made of gold. In another preferred embodiment, the top cap contact pad **735** is made of a combination of gold and titanium. In a preferred embodiment, the combination of gold and titanium includes a layer of gold located on top of a layer of titanium. The layer of titanium preferably improves the adhesion of the gold to silicon and silicon dioxide.

The top cap balanced metal pattern **730** is used to minimize bowing of the top cap wafer body **406**. Bowing of the top cap wafer body **406** is undesirable because it has an adverse effect on the performance of the accelerometer **305.** Bowing of the top cap wafer body **406** typically results from thermal coefficient of expansion (TCE) differences between the material of the top cap wafer body 406 and the metal of the top capacitor electrode **705**. In a preferred embodiment, the material of the top cap wafer body **406** is silicon. In a preferred embodiment, the top cap balanced metal pattern **730** is approximately identical in pattern and thickness to the top capacitor electrode **705** and is placed within the top cap press frame recess **725**, substantially opposite the top capacitor electrode **705**. In a preferred embodiment, the top cap balanced metal pattern **730** includes cutouts **731** to offset the cutouts **705** in the top capacitor electrode **705**. This alignment preferably creates a balanced metal/silicon/metal sandwich that helps minimize the TCE mismatch effects on accelerometer **305** performance.

The bottom cap wafer **420** may include any number of conventional commercially available components suitable for forming a bottom cap wafer. In a preferred embodiment, as illustrated in **FIGS. 8a, 8b, and 8c,** the bottom cap wafer **420** includes a bottom cap wafer body **421**, an upper surface **423**, a bottom surface **422**, a bottom capacitor electrode **805**, a bottom bond ring **807**, a bottom bond oxide ring **810**, a bottom cap parasitic groove **815**, bottom cap overshock bumpers **820**, a bottom cap press frame recess **825**, a bottom cap balanced metal pattern **830**, a bottom cap contact pad **835**, and an extended cap solder attach (ECSA) metal bond pad **840.**

The bottom cap wafer body **421** may be fabricated from any number of conventional commercially available materials suitable for creating a cap wafer body such as, for example, glass, quartz, ceramic, or silicon. In a preferred embodiment, the bottom cap wafer body **421** is made of silicon.

The bottom capacitor electrode **805** is preferably used for the time-based multiplexing of electrical signals from an external circuit, the operation of which is substantially as described in PCT patent application serial number PCT/US00/40038. The bottom capacitor electrode 805 is preferably located on the upper surface **423** of the bottom cap wafer body **421**, within an area circumscribed by the bottom cap parasitic groove **815**. In a preferred embodiment, as illustrated in **FIG. 8c**, the bottom capacitor electrode **805** includes cutouts **806** into which the bottom cap overshock bumpers **820** are fabricated. The bottom capacitor electrode **805** may be fabricated using any number of conductive materials suitable for creating an electrode such as, for example, metals, silicides, or doped semiconductors. In a preferred embodiment, the bottom capacitor electrode **805** is fabricated from a combination of gold and titanium. In a preferred embodiment, the combination of gold and titanium includes a layer of gold located on top of a layer of titanium. The layer of titanium preferably improves the adhesion of the gold to silicon and silicon dioxide.

The bottom bond ring **807** and the bottom bond oxide ring **810** preferably bond the bottom cap wafer **420** to the bottom measurement mass half **415** and help establish a narrow gap between the bottom capacitor electrode **805** and an electrode located on a lower surface of the bottom measurement mass half **415**. The bottom bond oxide ring **810** preferably provides electrical isolation between the bottom cap wafer **420** and the bottom measurement mass half **415.** The bottom bond ring **807** and the bottom bond oxide ring **810** are preferably located on the upper surface **423** of the bottom cap wafer body **421**. The bottom bond ring **807** may be fabricated from any number of materials suitable for making a bond ring such as, for example, aluminum, silver, or gold. In a preferred embodiment, the bottom bond ring **807** is fabricated from a combination of gold and titanium. In a preferred embodiment, the combination of gold and titanium includes a layer of gold located on top of a layer of titanium. The layer of titanium preferably improves the adhesion of the gold to silicon and silicon dioxide. In a preferred embodiment, the bond ring **807** has a width d4 that is smaller than the width of the bottom cap press frame recess **825**. In a preferred embodiment, the bond ring **807** extends beyond the bottom cap overshock bumpers **820** by a distance d3. The bottom bond oxide ring **810** may include any number of conventional commercially available materials suitable for making a bond oxide ring such as, for example, dielectrics. In a preferred embodiment, the bottom bond oxide ring **810** is fabricated from silicon dioxide.

The bottom cap parasitic groove **815** preferably minimizes the coupling of electrostatic feedback of an external close-loop circuit to springs included in the bottom measurement mass half **415**. The bottom cap parasitic groove **815** preferably is a groove within the upper surface **423** of the bottom cap wafer body **421.** The bottom cap parasitic groove **815** preferably circumscribes the bottom capacitor electrode **805**, and is surrounded by the bottom bond oxide ring **810**. The bottom cap parasitic groove **815** may include any dimensions suitable for creating an adequate parasitic groove. In a preferred embodiment, the bottom cap parasitic groove **815** measures greater than about 5 microns in depth and has a width wider than the width of the springs within the bottom measurement mass half **415.**

The bottom cap overshock bumpers **820** preferably provide out-of-plane shock protection to the bottom measurement mass half **415**. The bottom cap overshock bumpers **820** are preferably located on the upper surface **423** of the bottom cap wafer body **421**, and are exposed through the cutouts **806** in the bottom capacitor electrode 805. The bottom cap overshock bumpers **820** may be fabricated from any number of conventional commercially available materials suitable for creating overshock bumpers, such as, for example, dielectrics or silicon dioxide. In a preferred embodiment, the bottom cap overshock bumpers **820** are made of silicon dioxide. In a preferred embodiment, the bottom cap overshock bumpers **820** have a width w2. The bottom cap wafer **420** may include any number of bottom cap overshock bumpers **820.** The design and layout of the bottom cap overshock bumpers 820 may be affected by any number of factors. In a preferred embodiment, the design and layout of the bottom cap overshock bumpers **820** balances the need for good shock protection with the need for minimal stiction between the bottom cap overshock bumpers **820** and a metal electrode pattern **915** located on the bottom measurement mass half **415.** Stiction occurs when the bottom cap overshock bumpers **820** stick to the metal electrode pattern **915** on the bottom measurement mass half **415** during the operation of the accelerometer **305**. The stiction between the bottom cap overshock bumpers **820** and the metal electrode pattern located on the bottom measurement mass half **415** may be caused by any number of sources, such as, for example, imprinting of the bottom cap overshock bumpers **820** onto the metal electrode pattern **915** located on the bottom measurement mass half **415**, Van Der Waals forces, electrostatic forces, surface residues resulting from the manufacture of the accelerometer **305,** or package-induced stresses. In a preferred embodiment, the number of bottom cap overshock bumpers **820** on the bottom cap wafer **420** equals the number of top cap overshock bumpers **720** on the top cap wafer **405,** the variations of which are illustrated in **FIGS. 7d, 7e, 7f, 7g, 7h, 7i, 7j, 7k, and 7l.**

The bottom cap press frame recess **825** is preferably located on the bottom surface **422** of the bottom cap wafer body **421** between the bottom cap balanced metal pattern **830** and the outer edge of the bottom surface **422.** The bottom cap press frame recess **825** ensures that bond forces applied during a bonding process are localized to the bottom bond oxide ring **810** region. By localizing bond forces to the bottom bond oxide ring **810** region rather than to the region of the narrow gap between the bottom capacitor electrode **805** and the electrode located on an bottom surface of the bottom measurement mass half **415**, the narrow gap between the electrodes is maintained. The bottom cap press frame recess **825** may formed using any number of processing steps suitable for forming a press frame recess such as, for example, silicon etching. In a preferred embodiment, the bottom cap press frame recess **825** is etched into the bottom surface **422** of the bottom cap wafer body **421**. The bottom cap press frame recess **825** may include any dimensions suitable for creating a press frame recess. In a preferred embodiment, the bottom cap press frame recess **825** measures greater than about 20 microns in height and has a width wider than the width d4 of the bond ring **807**.

The bottom cap contact pad **835** is preferably located on the bottom surface **422** of the bottom cap wafer body **421**. The bottom cap contact pad **835** is preferably available for wafer probing. The bottom cap contact pad **835** may include any number of conventional commercially available materials suitable for creating a contact pad such as, for example, gold, aluminum, or silver. In a preferred embodiment, the bottom cap contact pad 835 is fabricated from a combination of gold and titanium. In a preferred embodiment, the combination of gold and titanium includes a layer of gold located on top of a layer of titanium. The layer of titanium preferably improves the adhesion of the gold to silicon and silicon dioxide.

The bottom cap balanced metal pattern **830** is used to minimize bowing of the bottom cap wafer body **421**. Bowing of the bottom cap wafer body **421** is undesirable because it has an adverse effect on the performance of the accelerometer **305**. Bowing of the bottom cap wafer body **421** typically results from thermal coefficient of expansion (TCE) differences between the material that makes up the bottom cap wafer body **421** and the metal of the bottom capacitor electrode **805**. In a preferred embodiment, the material that makes up the bottom cap wafer body **406** is silicon. In a preferred embodiment, the bottom cap balanced metal pattern **830** is approximately identical in pattern and thickness to the bottom capacitor electrode **805** and is placed within the bottom cap press frame recess **825,** substantially opposite the bottom capacitor electrode **805**. As illustrated in **FIG. 8b**, the bottom cap balanced metal pattern **830** preferably includes cutouts **831** designed to offset the cutouts **806** in the bottom capacitor electrode **805**. This alignment preferably creates a balanced metal/silicon/metal sandwich that helps minimize the TCE mismatch effects on accelerometer **305** performance.

The ECSA metal bond pad **840** is preferably available for conductive die-attach to an external package into which the accelerometer **305** is placed. The operation of the ECSA metal bond pad **840** is preferably as described in PCT patent application serial number PCT/CTS00/06832 filed on March 15, 2000, the disclosure of which is incorporated herein by reference.

The top measurement mass half **410** may include any number of conventional commercially available materials suitable for creating a measurement mass half. In a preferred embodiment, as illustrated in **FIGS. 9a, 9aa, 9ac, 9ad, 9b, 9c, and 9d,** the top measurement mass half **410** includes an upper surface **411,** a lower surface **412,** one or more springs **905**, a top measurement mass **906**, a housing **907**, the metal electrode pattern **910,** a bond ring **920**, and a top mass contact pad **930**. In another preferred embodiment, the top measurement mass half **410** further includes a groove **940**.

The springs **905** preferably couple the top measurement mass **906** to the housing **907** and provide a conductive path between the top measurement mass **906** and the housing **907**. The springs **905** may be fabricated from any number of conventional commercially available materials suitable for creating springs such as, for example, quartz, metals, or silicon. In a preferred embodiment, the springs **905** are made of silicon, and are micromachined out of the top measurement mass half **410** wafer. The springs **911** are preferably designed to maintain cross-axis rejection while providing lateral shock protection for the top measurement mass **906**. The springs **905** are preferably linear L-shaped springs, the design of which is described in U.S. Pat. Nos. 5,652,384 and 5,777,226, the disclosures of which are incorporated herein by reference.

The top measurement mass **906** is used to detect measurement data. The top measurement mass **906** may be used in any application in which its use is suitable. In a preferred embodiment, the top measurement mass **906** is used in seismic applications to detect acceleration. The top measurement mass **906** is preferably coupled to the housing **907** by the springs **905.** The top measurement mass **906** may be fabricated from any number of conventional commercially available materials suitable for creating a measurement mass such as, for example, metals, quartz, or silicon. In a preferred embodiment, the top measurement mass **906** is made of silicon, and is micromachined out of the top measurement mass half **410** wafer.

The housing **907** surrounds the top measurement mass **906** and is coupled to the top measurement mass **906** by the springs **905**. The housing **907** may be fabricated from any number of conventional commercially available materials suitable for creating a housing such as, for example, metals, quartz, or silicon. In a preferred embodiment, the housing **907** is fabricated from silicon, and is micromachined out of the top measurement mass half **410** wafer.

The metal electrode pattern **910** is used for the time-based multiplexing of electrical signals from an external circuit. In a preferred embodiment, the metal electrode pattern **910** includes a single electrode. In a preferred embodiment, the metal electrode pattern **910** is located on the upper surface **411** of the top measurement mass half **410,** on top of the top measurement mass **906**. The metal electrode pattern **910** may include any number of conventional commercially available materials suitable for creating an electrode pattern such as, for example, aluminum, silver, or gold. In a preferred embodiment, the metal electrode pattern **910** is fabricated from a combination of gold and titanium. In a preferred embodiment, the combination of gold and titanium includes a layer of gold located on top of a layer of titanium. The layer of titanium preferably improves the adhesion of the gold to silicon and silicon dioxide. In an alternate embodiment, the metal electrode pattern **910** may be fabricated using any number of conductive materials suitable for creating an electrode such as, for example, metals, silicides, or doped semiconductors.

The metal electrode pattern **910** may be of any size or shape suitable for forming an electrode pattern such as, for example, circular, square, or rectangular. The metal electrode pattern **910** is preferably substantially identical in size and shape to the top capacitor electrode **705**. In an alternative embodiment, the metal electrode pattern **910** is substantially equal in thickness to the bond ring **920**. In a preferred embodiment, the thicknesses of the metal electrode pattern **910** and the bond ring **920** are smaller than the thickness of the top bond ring **707**. The difference in thickness between the metal electrode pattern **910**, the bond ring **920**, and the top bond ring 707 preferably reduces stiction between the top cap overshock bumpers **720** and the metal electrode pattern **910** during the operation of the accelerometer **305** by reducing the imprinting of the top cap overshock bumpers **720** on the metal electrode pattern **910.**

In another preferred embodiment, as illustrated in **FIG. 9aa,** the metal electrode pattern **910** includes one or more patterns **960a** designed to minimize stiction between the top cap overshock bumpers **720** and the metal electrode pattern 910 during the operation of the accelerometer **305**. The patterns **960a** may include any shape suitable for reducing stiction within the accelerometer **305**. The patterns **960a** in the metal electrode pattern **910** preferably reduce stiction between the top cap overshock bumpers **720** and the metal electrode pattern **910** by minimising the surface area of the region of intimate contact between the top cap overshock bumpers **720** and the metal electrode pattern **910.**

In another preferred embodiment, as illustrated in FIG. 9ac, the metal electrode pattern **910** includes one or more reduced-thickness recesses **970a** at areas in which the top cap overshock bumpers **720** come in contact with the metal electrode pattern **910.** The reduced-thickness recesses **970a** in the metal electrode pattern **910** are preferably designed to reduce stiction between the top cap overshock bumpers 720 and the metal electrode pattern **910**. The reduced-thickness recesses **970a** may be formed using any suitable method for forming reduced-thickness recesses in the metal electrode pattern **910**. In a preferred embodiment, the reduced-thickness recesses **970a** are formed by removing the gold layer from the metal electrode pattern **910** to expose the underlying titanium layer. The reduced-thickness recesses **970a** may have any shape suitable for reducing stiction within the accelerometer **305**. In a preferred embodiment, the reduced-thickness recesses **970a** are wider than the width w1 of the top cap overshock bumpers **720**, and are located on the metal electrode pattern **910** at areas in which the top cap overshock bumpers **720** come in contact with the metal electrode pattern **910**. The reduced-thickness recesses **970**a in the metal electrode pattern **910** preferably reduce stiction between the top cap overshock bumpers **720** and the metal electrode pattern **910** by reducing the amount of imprinting in the metal electrode pattern **910** that occurs when the top cap overshock bumpers **720** come in contact with the metal electrode pattern **910.**

In another preferred embodiment, as illustrated in **FIG. 9ad**, the metal electrode pattern **910** includes one or more cavities **980a**. The cavities **980a** in the metal electrode pattern **910** are preferably designed to eliminate stiction between the top cap overshock bumpers **720** and the metal electrode pattern **910**. The cavities **980a** may be formed using any suitable method for forming cavities in the metal electrode pattern **910**. In a preferred embodiment, the cavities **980a** are formed by selectively removing the gold layer and the titanium layer from the metal electrode pattern **910** to expose the underlying top measurement mass half **410**. The cavities **980a** may have any shape suitable for reducing stiction within the accelerometer **305**. In a preferred embodiment, the cavities **980a** are wider than the width w1 of the top cap overshock bumpers **720,** and are located on the metal electrode pattern **910** at areas in which the top cap overshock bumpers **720** come in contact with the metal electrode pattern **910**. The cavities **980a** in the metal electrode pattern **910** preferably reduce stiction between the top cap overshock bumpers **720** and the metal electrode pattern **910** by eliminating imprinting in the metal electrode pattern **910** that occurs when the top cap overshock bumpers **720** come in contact with the metal electrode pattern **910**. The operation of the metal electrode pattern 910 is substantially as that described in PCT patent application serial number PCT/US00/40038.

The bond ring **920** facilitates bonding of the top measurement mass half **410** to the top cap wafer **405**. The bond ring **920** may include any number of conventional commercially available materials suitable for creating a bond ring such as, for example, gold, aluminum, or silver. In a preferred embodiment, the bond ring **920** is fabricated from a combination of gold and titanium. In a preferred embodiment, the combination of gold and titanium includes a layer of gold located on top of a layer of titanium. The layer of titanium preferably improves the adhesion of the gold to silicon and silicon dioxide. The bond ring **920** is preferably located on the upper surface **411** of the top measurement mass half **410,** adjacent to the inner edge of the housing **907.**

The top mass contact pad **930** is preferably used to make electrical contact to the top measurement mass half **410**. The top mass contact pad **930** may be located anywhere on the upper surface **411** of the housing **907**. In a preferred embodiment, the top mass contact pad **930** is located on the outer edge of the upper surface **411** of the housing **907**, away from the metal electrode pattern **910**. The top mass contact pad 930 may be fabricated from any materials suitable for creating a contact pad such as, for example, silver, aluminum, or gold. In a preferred embodiment, the top mass contact pad 930 is made of a combination of gold and titanium. In a preferred embodiment, the combination of gold and titanium includes a layer of gold located on top of a layer of titanium. The layer of titanium preferably improves the adhesion of the gold to silicon and silicon dioxide. The top mass contact pad **930** may include any dimensions suitable for creating a contact pad. In a preferred embodiment, the top mass contact pad **930** is sufficiently large for enabling a conventional wire bond.

The groove **940** is preferably located on the lower surface **412** of the housing **907** and extends from the outer edge of the housing **907** to the inner edge of the housing **907**. The groove **940** preferably forms a passage **950** when the top measurement mass half **410** is bonded to the bottom measurement mass half **415**. The passage **950** is preferably used to remove air from a cavity within the accelerometer **305**, creating a vacuum or a low-pressure environment within the accelerometer **305** when the accelerometer **305** is sealed within a vacuum package. The groove **940** may be shaped in any way suitable for creating a passage for venting air. In a preferred embodiment, the groove **940** is V-shaped. In a preferred embodiment, the groove **940** is designed to allow for the fluidic flow of air from within the accelerometer **305** during a vacuum pump-down. The top measurement mass half **410** may include any number of grooves **940**. In a preferred embodiment, the top measurement mass half **410** includes two grooves **940**. In an alternative embodiment, the top measurement mass half **410** includes one groove **940**. In an alternative embodiment, the top measurement mass half **41**0 includes a plurality of grooves **940**. In an alternative embodiment, the top measurement mass half **410** includes no groove **940**. The shape of the groove **940** may be affected by any number of factors. In a preferred embodiment, the groove **940** is designed to achieve an optimal pumpdown time for air passing through the passage **950**. The conductance of air through the passage **950** is preferably given by:

$$C = \frac{8}{3\sqrt{\pi}} \left( \frac{2kT}{m} \right)^{1/2} \left( \frac{A^2}{BL} \right), \qquad (1)$$

where:
    C = the conductance of the passage **950,**
    k = Boltzman's constant,
    T = absolute temperature,
    m = mass of gas atom,
    A = cross-sectional area of the passage **950**,
    B = periphery of the cross-sectional area of the passage **950,** and
    L = the length of the passage **950.**

The dimensions of the passage **950**, such as the length L, the cross-sectional area A, and the periphery B, are preferably designed to optimize the conductance of air through the passage **950**. In a preferred embodiment, the optimal conductance C through the passage **950** produces an optimal pumpdown time for removing air from within the accelerometer **305**. The pumpdown time is the amount of time it takes to remove enough air from within the accelerometer **305** to achieve the desired pressure within the accelerometer **305**. The pumpdown time is preferably given by:

$$t \approx \left(\frac{V}{S}\right)\left[1 - S/C\right]\ln\left(\frac{Pi - Pu}{P - Pu}\right) \qquad (2)$$

where:

t = pumpdown time,

V = volume of the internal cavities within the accelerometer **305**,

S = speed of a vacuum pump used to remove air from the accelerometer **305,**

C = conductance of the passage **950** from equation (1),

Pi = initial pressure within the accelerometer **305** (typically 1 atm),

P = desired pressure within the accelerometer **305,**

Pu = (1+S/C)*Po, and

Po = lowest pressure of the pump.

The bottom measurement mass half **415** may be fabricated from any number of conventional commercially available materials suitable for creating a measurement half. In a preferred embodiment, as illustrated in **FIGS. 9a, 9ab, 9ac, 9ad, 9e, 9f,** and **9g,** the bottom measurement mass half **415** includes an upper surface **417**, a lower surface **416**, one or more springs **911**, a bottom measurement mass **912**, a housing **913**, the metal electrode pattern **915,** a bond ring **925,** a bottom mass contact pad **935,** and a groove **945.**

The springs **911** preferably couple the bottom measurement mass **912** to the housing **913** and provide a conductive path between the bottom measurement mass **912** and the housing **913.** The springs **911** may be fabricated from any number of conventional commercially available materials suitable for creating springs such as, for example, metals, quartz, polysilicon, or silicon. In a preferred embodiment, the springs **911** are made of silicon, and are micromachined out of the bottom measurement mass half **415** wafer. The springs **911** are preferably designed to maintain cross-axis rejection while providing lateral shock protection for the bottom measurement mass **912**. The springs **911** are preferably linear L-shaped springs, the design of which is described in U.S. Pat. Nos. 5,652,384 and 5,777,226, the disclosures of which are incorporated herein by reference.

The bottom measurement mass **912** is used to detect measurement data. The bottom measurement mass **912** may be used in any application in which its use is suitable. In a preferred embodiment, the bottom measurement mass **912** is used in seismic applications to detect acceleration forces. The bottom measurement mass **912** is preferably coupled to the housing **913** by the springs **911**. The bottom measurement mass **912** may be fabricated from any material suitable for creating a measurement mass such as, for example, silicon or quartz. In a preferred embodiment, the bottom measurement mass **912** is made of silicon, and is micromachined out of the bottom measurement mass half **415** wafer.

The housing **913** surrounds the bottom measurement mass **912** and is coupled to the bottom measurement mass **912** by the springs **911**. The housing **913** may be fabricated from any material suitable for creating a housing such as, for example, quartz or silicon. In a preferred embodiment, the housing **913** is fabricated from silicon, and is micromachined out of the bottom measurement mass half **415** wafer.

The metal electrode pattern **915** is used for the time-based multiplexing of electrical signals from an external circuit. In a preferred embodiment, the metal electrode pattern **915** includes a single electrode. In a preferred embodiment, the metal electrode pattern **915** is located on the lower surface **416** of the bottom measurement mass half **415**, on a surface of the bottom measurement mass **912**. The metal electrode pattern **915** may include any number of conventional commercially available materials suitable for creating an electrode pattern such as, for example, silver, aluminum, or gold. In a preferred embodiment, the metal electrode pattern **915** is made of a combination of gold and titanium. In a preferred embodiment, the combination of gold and titanium includes a layer of gold located on top of a layer of titanium. The layer of titanium preferably improves the adhesion of the gold to silicon and silicon dioxide. In an alternate embodiment, the metal electrode pattern **915** may be fabricated using any number of conductive materials suitable for creating an electrode such as, for example, metals, silicides, or doped semiconductors.

The metal electrode pattern **915** may be of any size or shape suitable for forming an electrode pattern such as, for example, circular, square, or rectangular. The metal electrode pattern **915** is preferably identical in size and shape to the bottom capacitor electrode **805**. In a preferred embodiment, the metal electrode pattern **915** is substantially equal in thickness to the bond ring **925**. In a preferred embodiment, the thicknesses of the metal electrode pattern **915** and the bond ring **925** are smaller than the thickness of the bottom bond ring **807**. The differences in thickness between the metal electrode pattern **915,** the bond ring **925,** and the bottom bond ring **807** preferably reduces stiction between the bottom cap overshock bumpers **820** and the metal electrode pattern **915** during the operation of the accelerometer **305** by reducing the imprinting of the bottom cap overshock bumpers **820** on the metal electrode pattern **915**.

In another preferred embodiment, as illustrated in **FIG. 9ab,** the metal electrode pattern **915** includes one or more patterns **960b** designed to minimize stiction between the bottom cap overshock bumpers **820** and the metal electrode pattern **915** during the operation of the accelerometer **305**. The patterns **960b** in the metal electrode pattern 915 preferably reduce stiction between the bottom cap overshock bumpers **820** and the metal electrode pattern **915** by minimizing the surface area of the region of intimate contact between the bottom can overshock bumpers **820** and the metal electrode pattern **915.**

In another preferred embodiment, as illustrated in **FIG. 9ac**, the metal electrode pattern **915** includes one or more reduced-thickness recesses **970b** at areas in which the bottom cap overshock bumpers **820** come in contact with the metal electrode pattern 915. The reduced-thickness recesses **970b** in the metal electrode pattern **915** are preferably designed to reduce stiction between the bottom cap overshock bumpers **820** and the metal electrode pattern **915.** The reduced-thickness recesses **970b** may be formed using any suitable method for forming reduced-thickness recesses in the metal electrode pattern **915.** In a preferred embodiment, the reduced-thickness recesses **970b** are formed by removing the gold layer from the metal electrode pattern **915** to expose the underlying titanium layer. The reduced-thickness recesses **970b** may have any shape suitable for reducing stiction within the accelerometer **305.** In a preferred embodiment, the reduced-thickness recesses **970b** are wider than the width w2 of the bottom cap overshock bumpers **820,** and are located on the metal electrode pattern **915** at areas in which the bottom cap overshock bumpers **820** come in contact with the metal electrode pattern **915.** The reduced-thickness recesses **970b** preferably reduce stiction between the bottom cap overshock bumpers **820** and the metal electrode pattern **915** by reducing the amount of imprinting in the metal electrode pattern **915** that occurs when the bottom cap overshock bumpers 820 come in contact with the metal electrode pattern **915.**

In another preferred embodiment, as illustrated in **FIG. 9ad**, the metal electrode pattern **915** includes one or more cavities **980b**. The cavities **980b** in the metal electrode pattern **915** are preferably designed to eliminate stiction between the bottom cap overshock bumpers **820** and the metal electrode pattern **915**. The cavities **980b** may be formed using any suitable method for forming cavities in the metal electrode pattern **915**. In a preferred embodiment, the cavities **980b** are formed by selectively removing the gold layer and the titanium layer from the metal electrode pattern **915** to expose the underlying bottom measurement mass half **415.** The cavities **980b** may have any shape suitable for reducing stiction within the accelerometer **305.** In a preferred embodiment, the cavities **980b** are wider than the width w2 of the bottom cap overshock bumpers **820,** and are located on the metal electrode pattern **915** at areas in which the bottom cap overshock bumpers **820** come in contact with the metal electrode pattern **915**. The cavities **980b** preferably reduce stiction between the bottom cap overshock bumpers **820** and the metal electrode pattern **915** by eliminating imprinting in the metal electrode pattern **915** that occurs when the bottom cap overshock bumpers **820** come in contact with the metal electrode pattern **915**. The operation of the metal electrode pattern **915** is substantially as that described in PCT patent application serial number PCT/US00/40038.

The bond ring **925** preferably facilitates bonding of the bottom measurement mass half **415** to the bottom cap wafer **420**. The bond ring **925** may include any number of conventional commercially available materials suitable for creating a bond ring such as, for example, gold, aluminum, or silver. In a preferred embodiment, the bond ring **925** is made of a combination of gold and titanium. In a preferred embodiment, the combination of gold and titanium includes a layer of gold located on top of a layer of titanium. The layer of titanium preferably improves the adhesion of the gold to silicon and silicon dioxide. The bond ring **925** is preferably located on the lower surface **416** of the bottom measurement mass half **415**, adjacent to the inner edge of the housing **913**.

The bottom mass contact pad **935** is preferably used to create an electrical contact to the bottom measurement mass half **415**. The bottom mass contact pad **935** may be located anywhere on the lower surface **416** of the housing **913**. In a preferred embodiment, the bottom mass contact pad **935** is located on the outer edge of the lower surface **416** of the housing **913**, away from the metal electrode pattern **915**. The bottom mass contact pad **935** may include any number of conventional commercially available materials suitable for creating a contact pad such as, for example, aluminum, silver, or gold. In a preferred embodiment, the bottom mass contact pad **935** is made of a combination of gold and titanium. In a preferred embodiment, the combination of gold and titanium includes a layer of gold located on top of a layer of titanium. The layer of titanium preferably improves the adhesion of the gold to silicon and silicon dioxide. The bottom mass contact pad **935** may include any dimensions suitable for a contact pad. In a preferred embodiment, the bottom mass contact pad **935** is sufficiently large for enabling conventional wire bonding.

The groove **945** forms a passage **950** when the bottom measurement mass half **415** is bonded to the top measurement mass half **410**. The passage **950** is preferably used to remove air from a cavity within the accelerometer **305**, creating a vacuum within the accelerometer **305** when the accelerometer **305** is sealed within a vacuum package. The groove **945** may be shaped in any way suitable for creating a passage for venting air. In a preferred embodiment, the groove **945** is V-shaped. In a preferred embodiment, the groove **945** is designed to allow for the fluidic flow of air from within the accelerometer **305** during a vacuum pump down. The shape of the groove **945** is preferably substantially identical to the shape of the groove **940,** as described above. The groove **945** is preferably located on the upper surface **417** of the housing **913** and extends from the outer edge of the housing **913** to the inner edge of the housing **913**. The bottom measurement mass half **415** may include any number of grooves **945.** In a preferred embodiment, the bottom measurement mass half **415** includes two grooves **945.** In an alternative embodiment, the bottom measurement mass half **415** includes one groove **945.** In an alternative embodiment, the bottom measurement mass half **415** includes a plurality of grooves **945.** In an alternative embodiment, the bottom measurement mass half **415** includes no groove 945.

Referring to **FIGS. 10, 11a, 11b, 11c, 11d, 11e, 11f, 11g, 11h, 11ha, 11hb, 11hc, 11hd, 11he, 11hf, 11hg, 11hh, 11hi, 11hj, 11i, 11j,** 12a, 12b, 12c, and 13, a method 1000 of fabricating the accelerometer **305** will now be described. In a preferred embodiment, the method **1000** of fabricating the accelerometer **305** includes: acquiring two starting cap wafers in step **1005**, shaping the two starting wafers using a cap wafer process in step **1010**, acquiring two starting mass wafers in step **1020**, shaping the two starting mass wafers using a mass wafer process in step **1025**, bonding the wafers to form the accelerometer **305** using a bonding process in step **1035**, making dicing cuts on the accelerometer **305** in step **1040,** and packaging the accelerometer **305** in step **1045.**

As illustrated in **FIG. 11a,** in step **1005** the two starting cap wafers **1105a** and **1105b** are fabricated. In a preferred embodiment, the two starting cap wafers **1105a** and **1105b** are identically sized and shaped. The starting cap wafers **1105a** and **1105b** may be fabricated from any number of conventional commercially available materials. In a preferred embodiment, the starting cap wafers **1105a** and **1105b** are made of silicon.

As illustrated in FIG. **11b,** in step **1010** the two starting cap wafers **1105a** and **1105b** undergo a cap wafer process. In a preferred embodiment, the cap wafer process transforms the starting cap wafers **1105a** and **1105b** into the top cap wafer **405** and the bottom cap wafer **420**, respectively. In an alternative embodiment, the cap wafer process includes a merged mask micro-machining process substantially as disclosed in one or more of the following: U.S. Patent Application serial no. 09/352,835, attorney docket number 14737.659.02, filed on July 13, 1999, and U.S. Patent Application serial no. 09/352,025, attorney docket number 14737.659.03, filed on July 13, 1999, the disclosures of which are incorporated herein by reference.

As illustrated in **FIG. 11c,** in step **1020** the two starting mass wafers **1120a** and **1120b** are fabricated. In a preferred embodiment, the two starting mass wafers **1120a** and **1120b** are identically sized and shaped. The starting mass wafers **1120a** and **1120b** may be fabricated from any number of conventional commercially available materials. In a preferred embodiment, the starting mass wafers **1120a** and **1120b** are made of silicon. In a preferred embodiment, each of the starting mass wafers **1120a** and **1120b** includes an etch-stop layer **1140a** and **1140b,** respectively. In a preferred embodiment, each of the starting mass wafers **1120a** and **1120b** includes an etch-masking layer **1150a** and **1150b,** respectively.

As illustrated in **FIGS. 11d, 11e, 11f, 11g, 11h, 11ha, 11hb, 11hc, 11hd, 11he, 11hf, 11hg, 11hh, 11hi, 11hj** and **11i,** in step **1025** the two starting mass wafers **1120a** and **1120b** undergo a mass wafer process that transforms the two starting mass wafers **1120a** and **1120b** into the top measurement mass half **410** and the bottom measurement mass half **415,** respectively. In a preferred embodiment, the mass wafer process is substantially as that described in U.S. Pat. No. 5,484,073, the disclosure of which is incorporated herein by reference. In an alternative embodiment, the mass wafer process includes a merged mask micromachining process substantially as disclosed in U.S. Patent Application serial no. 09/352,835, attorney docket number 14737.659.02, filed on July 13, 1999, and U.S. Patent Application serial no. 09/352,025, attorney docket number 14737.659.03, filed on July 13, 1999, the disclosures of which are incorporated herein by reference.

As illustrated in FIG. **11d,** the mass wafer process of step **1025** begins by photolithigraphically patterning the etch-masking layer **1150a** to create an area of exposure **1160** on the etch-masking layer **1150a.** In a preferred embodiment, the etch-masking layer **1150a** is photolithigraphically patterned to create the area of exposure **1160** in the shape of the top measurement mass **906,** the housing **907,** and the grooves **940**. In a preferred embodiment, the photolithigraphically patterned area of exposure **1160** includes corner compensation structures X and Y.

In a preferred embodiment, as illustrated in **FIG. 11e,** an etching process is performed to shape the starting mass wafer **1120a** into the top measurement mass half **410**. The etching process may include any number of conventional commercially available processes suitable for etching. In a preferred embodiment, the etching process begins by removing the etch-masking layer **1150a** from the starting mass wafer **1120** within the area of exposure **1160.** The etch-masking layer **1150a** may be removed using any suitable process for removing an etch-masking layer, such as, for example, plasma etching. In a preferred embodiment, the etch-masking layer **1150a** is removed from the starting mass wafer **1120a** within the area of exposure **1160** by using an etchant. In a preferred embodiment, removal of the etch-masking layer **1150a** exposes the material from which the starting mass wafer **1120a** is fabricated. In a preferred embodiment, the material from which the starting mass wafer **1120a** is fabricated is silicon. In a preferred embodiment, the comer compensation structures X prevent the etchant from attacking and corroding convex corners within the area of exposure **1160**. The corner structures Y preferably allow the grooves **940** to be simultaneously formed during the etching process used to define the measurement mass **906** and the housing **907**. In a preferred embodiment, the corner compensation structures Y reduce etchant-induced corner erosion at an intersection between the grooves **940** and the area of exposure **1160**.

In a preferred embodiment, a wet etching chemical is then applied to the exposed silicon on the starting mass wafer **1120a.** The wet etching chemical may be any number of conventional commercially available wet etching chemicals suitable for etching silicon. In a preferred embodiment, the wet etching chemical is potassium hydroxide (KOH). The KOH preferably controllably etches through the silicon and terminates at the etch-stop layer **1140a** of the starting mass wafer **1120a.** In a preferred embodiment, as illustrated in **FIG. 11f,** the KOH etches the starting mass wafer **1120a** into the shape of the top measurement mass **406**, the housing **407,** and the groove **940.** In a preferred embodiment, the etch-stop layer **1140a** remains on the backside surface of the springs 905 after the wet chemical etching process has been completed. In an alternative embodiment, the etch-stop layer **1140a** is removed from the springs 905 during the wet chemical etching process.

Following the wet etching process, the remaining etch-masking layer **1150a** on the starting mass wafer **1120a** is removed from the starting mass wafer **1120a** using a standard wet etchant.

An identical etching process is preferably used on the second starting mass wafer 1120b to shape the second starting mass wafer **1120b** into the bottom measurement mass half 415.

In a preferred embodiment, as illustrated in **FIG. 11g**, the top measurement mass half **410** and the bottom measurement mass half **415** are bonded together to form a mass wafer pair **1130.** The wafer bonding process may be any number of bonding processes suitable for bonding the top measurement mass half **410** and the bottom measurement mass half **415.** In a preferred embodiment, the wafer bonding process is a fusion bonding process. In a preferred embodiment, the groove **940** in the top measurement mass half **410** is aligned with the groove **945** in the bottom measurement mass half **415** during the wafer bonding process to form the passage **950.**

In a preferred embodiment, a metal layer **1142** is deposited onto the upper surface of the mass wafer pair **1150,** which corresponds to the upper surface **411** of the top measurement mass half **410.** Additionally, a metal layer **1143** is deposited onto the lower surface of the mass wafer pair **1130,** which corresponds to the lower surface **416** of the bottom measurement mass half **415.** The metal layers **1142** and **1143** may include any number of conventional commercially available materials suitable for creating a metal layer such as, for example, aluminum, silver, or gold. In a preferred embodiment, the metal layers **1142** and **1143** are fabricated from a combination of gold and titanium. In a preferred embodiment, the combination of gold and titanium includes a layer of gold located on top of a layer of titanium. The layer of titanium preferably improves the adhesion of the gold to silicon and silicon dioxide. The metal layers **1142** and **1143** are preferably patterned using an etch-masking layer. The etch-masking layer may be any etch-masking layer suitable for patterning metal layers. In a preferred embodiment, the etch-masking layer is photoresist. The metal layers **1142** and **1143** may be shaped into any pattern suitable for use within the accelerometer **305.** In a preferred embodiment, as illustrated in FIG. **11h,** the metal layer **1142** on the upper surface of the mass wafer pair **1130** is shaped to form the metal electrode pattern **910,** the bond ring **920,** and the top mass contact pad **930.** In a preferred embodiment, as illustrated in **FIG. 11h,** the metal layer **1143** on the lower surface of the mass wafer pair **1130** is shaped to form the metal electrode pattern **915,** the bond ring **925,** and the bottom mass contact pad **935.**

In a preferred embodiment, as illustrated in **FIG. 11ha,** the metal electrode pattern **910** includes a pattern **960a** designed to reduce stiction between the metal electrode pattern **910** and the top cap overshock bumpers **720** during the operation of the accelerometer **305.** In a preferred embodiment, as illustrated in **FIG. 11hb,** the metal electrode pattern **915 includes** a pattern **960b** designed to reduce stiction between the metal electrode pattern **915** and the bottom cap overshock bumpers **820** during the operation of the accelerometer **305.** The patterns **960a** and **960b** may be created on the metal electrode patterns **910** and **915** using any number of methods suitable for creating patterns on the metal electrode patterns **910** and **915.** In a preferred embodiment, as illustrated in **FIG. 11ha,** the pattern **960a** is created by etching a pattern into the upper surface **411** of the top measurement mass half **410** to create a patterned surface **1165a,** and depositing the metal layer **1142** onto the patterned surface **1165a.** The metal layer **1142** preferably molds into the metal electrode **910** including the pattern **960a.** In a preferred embodiment, as illustrated in **FIG. 11hb,** the pattern **960b** is created by etching a pattern into the lower surface **416** of the bottom measurement mass half **415** to create a patterned surface **1165b,** and depositing the metal layer **1143** onto the patterned surface **1165b.** The metal layer **1143** preferably molds into the metal electrode **915** including the pattern **960b.** The patterned surface **1165a** etched into the upper surface **411** of the top measurement mass half **410** and the patterned surface **1165b** etched into the lower surface **416** of the bottom measurement mass half **415** may include any number of patterns suitable for reducing the stiction between the metal electrode patterns **910** and **915** and the overshock protection bumpers **720** and **820,** respectively. In a preferred embodiment, as illustrated in **FIGS. 11hc** and **11hf,** the patterned surfaces **1165a** and **1165b** include a plurality of geometrically arranged squares. In another preferred embodiment, as illustrated in **FIGS. 11hd** and **11hg,** the patterned surfaces **1165a** and **1165b** include a plurality of geometrically arranged circles. In another preferred embodiment, as illustrated in **FIG. 11he,** the patterned surfaces **1165a** and **1165b** include a series of concentric circles. In another preferred embodiment, as illustrated in **FIG. 11hh,** the patterned surfaces **1165a** and **1165b** include a series of geometrically arranged rectangles. In another preferred embodiment, as illustrated in **FIGS. 11hi** and **11hj,** the patterned surfaces **1165a** and **1165b** include a series of geometrically arranged pie-shaped segments.

In a preferred embodiment, as illustrated in **FIG. 11i,** the springs **905** are formed to couple the top measurement mass **906** to the housing **907,** and the springs **911** are formed to couple the bottom measurement mass **912** to the housing **913.** The springs **905** and **911** may be formed using any number of conventional commercially available methods suitable for creating spring members in the mass wafer pair **1130.-** In a preferred embodiment, the springs **905** and **911** are formed using a DRIE plasma etching technique. In a preferred embodiment, the etching technique is substantially as that described in U.S. Patent No. 5,484,073, the disclosure of which is incorporated herein by reference. The springs **905** and **911** are preferably linear L-shaped springs, the design of which is described in U.S. Pat. Nos. 5,652,384 and 5,777,226, the disclosures of which are incorporated herein by reference. The springs **905** and **911** are preferably designed to maintain cross-axis rejection while providing lateral shock protection for the top measurement mass **906** and the bottom measurement mass **911,** respectively. In a preferred embodiment, the etch-stop layers **1140a** and **1140b** remain on backside surfaces of the springs **905** and **911,** respectively, after the plasma etching process has been completed. The etch-stop layers **1140a** and **1140b** on the springs **905** and **911** preferably improve the uniformity of the thickness of the springs **905** and **911.** In addition, the etch-stop layers **1140a** and **1140b** on the springs **905** and **911** preferably improve the dimensional control of the springs **905** during the operation of the accelerometer 305. In another preferred embodiment, the etch-stop layers **1140a** and **1140b** are removed from the springs **905** and **911,** respectively, during the plasma etching process.

As illustrated in **FIG. 11j,** in step **1035** the top cap wafer **405,** the bottom cap wafer **420**, and the mass wafer pair **1130** preferably undergo a bonding process to form the accelerometer **305.** The bonding process of step **1035** may be any number of bonding processes such as, for example, fusion bonding, thermocompression, eutectic bonding, anodic bonding, or glass frit bonding. In a preferred embodiment, the bonding process of step **1035** is a thermocompression bonding process.

During the bonding process of step **1035,** the top cap wafer **405** is bonded to the upper surface of the mass wafer pair **1130,** which corresponds to the upper surface **411** of the top measurement mass half **410.** In a preferred embodiment, the top bond ring **707** bonds with the bond ring **920,** coupling the top cap wafer **405** and the top measurement mass half **410.** The top bond ring **707** and the bond ring **920** are preferably bonded using the thermocompression bonding process.

The top bond oxide ring **710** preferably extends below the bottom surface **408** of the top cap wafer body **406.** As a result, the bonding process preferably creates a narrow capacitor electrode gap between the top capacitor electrode **705** and the metal electrode pattern **910.** During the bonding process, bond forces are preferably applied to the upper surface **407** of the top cap wafer **405,** away from the top cap press frame recess **725.** In a preferred embodiment, the top cap press frame recess **725** is positioned on the upper surface **407** of the top cap wafer **405** in a location that ensures that bond forces applied during the bonding process are localized to the bond ring regions and away from the narrow capacitor electrode gap region.

Also during the bonding process of step **1035,** the bottom cap wafer **420** is bonded to the lower surface of the mass wafer pair **1130,** which corresponds to the lower surface **416** of the bottom measurement mass half **415.** In a preferred embodiment, the bottom bond ring **807** bonds with the bond ring **925,** coupling the bottom cap wafer **420** and the bottom measurement mass half **415.** The bottom bond ring **807** and the bond ring **925** are preferably bonded using the thermocompression bonding process.

The bottom bond oxide ring **810** preferably extends above the upper surface **423** of the bottom cap wafer body **421.** As a result, the bonding process preferably creates a narrow capacitor electrode gap between the bottom capacitor electrode **805** and the metal electrode pattern **915.** During the bonding process, bond forces are preferably applied to the bottom surface **422** of the bottom cap wafer **420,** away from bottom cap press frame recess **825.** In a preferred embodiment, the bottom cap press frame recess **825** is positioned on the bottom surface **422** of the bottom cap wafer **420** in a location that ensures that bond forces applied during the bonding process are localized to the bond ring regions and away from the narrow capacitor electrode gap region.

As illustrated in **FIGS. 12a, 12b, and 12c,** in step **1040** the accelerometer **305** undergoes a dicing process. Dicing cuts **1205, 1210, 1215, 1220** are preferably made at predetermined locations on the accelerometer **305.** The dicing cuts **1205, 1210, 1215, 1220** serve a variety of purposes. In a preferred embodiment, the dicing cuts **1205, 1215, 1220** are made to separate the accelerometer **305** die from a wafer **1235,** expose electrical leads from the electrodes **910** and **915,** separate the electrical leads, and expose the passage **950.** In another preferred embodiment, the dicing cut **1210** is made in addition to the dicing cuts **1205, 1215, 1220** to separate the accelerometer **305** die from the wafer **1235,** expose electrical leads from the electrodes **910** and **915,** separate the electrical leads, and expose the passage **950.**

In a preferred embodiment, a cut **1205** is made on the top cap wafer **405.** The cut **1205** preferably extends vertically through the top cap wafer body **406,** resulting in the removal of a section of the top cap wafer body **406.** In a preferred embodiment, the cut **1205** exposes the top mass contact pad **930.** The cut **1205** may be performed using any number of conventional commercially available methods of performing a dicing cut such as, for example, using a diamond blade wafer saw. In a preferred embodiment, the cut **1205** is made by using a diamond blade wafer saw.

In a preferred embodiment, a cut **1215** is made extending vertically through the top cap wafer body **406** and into the housing **907** of the top measurement mass half **410.** The cut **1215** is preferably stopped within the housing **907** before the cut **1215** reaches the passage **950**. The cut **1215** may be stopped any distance before reaching the passage **950**. In a preferred embodiment, the cut **1215** is stopped more than about 2 mils from the passage **950**. The cut **1215** may be performed using any number of conventional commercially available methods of performing a dicing cut such as, for example, using a diamond blade wafer saw. In a preferred embodiment, the cut **1215** is made by using a diamond blade wafer saw.

In a preferred embodiment, a cut **1220** is made extending vertically through the bottom cap wafer body **421** and into the housing **913** of the bottom measurement mass half **415**. The cut **1220** is preferably stopped within the housing **913** before the cut **1220** reaches the passage **950**. The cut **1220** may be stopped any distance before reaching the passage **950**. In a preferred embodiment, the cut **1220** is stopped more than about 2 mils from the passage **950**. The cut **1220** may be performed using any number of conventional commercially available methods of performing a dicing cut such as, for example, using a diamond blade wafer saw. In a preferred embodiment, the cut **1215** is made by using a diamond blade wafer saw.

In an alternative preferred embodiment, a cut **1210** is made on the bottom cap wafer body **421**. The cut **1210** preferably extends vertically through the bottom cap wafer body **421**, resulting in the removal of a section of the bottom cap wafer body **421**. In a preferred embodiment, the cut **1210** exposes the bottom mass contact pad **935**. The cut **1210** may be performed using any number of conventional commercially available methods of performing a dicing cut such as, for example, using a diamond blade wafer saw. In a preferred embodiment, the cut **1210** is made by using a diamond blade wafer saw.

The cuts **1205, 1210, 1215, 1220** may be performed individually, or the cuts **1205, 1210, 1215, 1220** may be made in any combination to achieve the accelerometer **305** shape most suitable for a particular application. In a preferred embodiment, as illustrated in **FIG. 12b**, cuts **1205, 1215,** and **1220** are performed on the accelerometer **305**. In an alternative embodiment, cut **1210** is performed on the accelerometer **305** in addition to the cuts **1205, 1215,** and **1220**. Cut **1205** preferably exposes the top mass contact pad **930**. Cut **1210** preferably exposes the bottom mass contact pad **935**. Cuts **1215, 1220** preferably create a scribe lane **1230** surrounding the passage **950**. The scribe lane **1230** is preferably attached to another die **1235**.

During the dicing process, the scribe lane **1230** may remain attached to the accelerometer **305** and die **1235** to keep the accelerometer **305** hermetically sealed, or the scribe lane **1230** may be snapped to expose the passage **950** and separate the accelerometer **305** from the die **1235**. In a preferred embodiment, as illustrated in **FIG. 12c**, the scribe lane **1230** is removed to expose the passage **950** and separate the accelerometer **305** from the die **1235**. The exposed passage **950** is preferably used as a channel for removing air from within the accelerometer **305** to create a vacuum within the accelerometer **305** during packaging.

As illustrated in **FIG. 13,** in step **1045** the accelerometer **305** is packaged within a package **1305**. The package **1305** may include any number of packages suitable for storing the accelerometer **305**. In a preferred embodiment, the package **1305** is a housing. In another preferred embodiment, the package **1305** is a substrate.

The housing **1305** may be any number of housings suitable for storing the accelerometer **305.** In a preferred embodiment, the housing **1305** includes a body **1310** and a lid **1315**. The housing **1305** is preferably a conventional multi-layered ceramic package.

The accelerometer **305** is preferably placed within the body **1310** of the housing **1305**. The accelerometer **305** may be placed within the housing **1305** using any number of methods suitable for securing the accelerometer **305** within the housing **1305**. In a preferred embodiment, the accelerometer **305** is placed within the housing **1305** using a solder-die attachment process substantially as disclosed in PCT Patent Application Serial No. PCT/US00/06832.

The lid **1315** is then preferably fastened to the body **1310** to seal the accelerometer **305** within the housing **1305**. In a preferred embodiment, a vacuum process is used to remove air from the housing prior to fastening the lid **1315** to the body **1310**, creating a vacuum or a low-pressure environment within the housing **1305**. When the passage **950** is exposed, air is removed from within the accelerometer **305** during the vacuum process, creating a vacuum within the accelerometer **305** in the housing **1305.**

In another preferred embodiment, the bonding process of step **1035** is performed in a vacuum environment, creating a vacuum within the cavity in the accelerometer **305** during the bonding process. In this embodiment, the passage **950** is preferably removed from the design of the accelerometer **305**. The vacuum-sealed accelerometer **305** is then preferably placed in the housing **1305**, and the housing is sealed by fastening the lid 1315 to the body **1310**.

Referring now to **FIG. 14**, an embodiment of an assembly **1400** for resiliently coupling a mass **1405** to a support **1410** using folded beams **1415a-1415d** will now be described.

Each folded beam **1415** includes an inner foot **1420** coupled to the mass **1405** and an outer foot **1425** coupled to the support **1410**. Extending from the feet **1420** and **1425** are corresponding inner and outer legs, **1430** and **1435**, that are joined by a head **1440**. The connection between the inner foot **1420** and the mass **1405** includes a circular cutout **1445**, the connection between the outer foot **1425** and the support **1410** includes a circular cutout **1450**, and the connection between the legs, **1430** and **1435**, and the head **1440** includes a circular cutout **1455**. The circular cutouts **1445, 1450,** and **1455** provide stress relief.

In a preferred embodiment, the teachings of the assembly **1400** are incorporated into the top measurement mass half **410** and the bottom measurement mass half **415** of the accelerometer **305** in order to optimally support the top measurement mass **906** and the bottom measurement mass **912** during operation of the accelerometer **305**. In a preferred embodiment, the first and second natural frequencies of the folded beams **1415a-1415d** are separated by at least about 80 kHz in order to provide optimally stable closed-loop operation of the accelerometer **305.**

Referring now to **FIGS. 14a** and **14b**, in several exemplary embodiments, the operational performance of the folded beam **1415** is given by the following expressions:

$$K \propto \left(\frac{T}{L}\right)^2 \equiv \left(\frac{2T}{2L}\right)^3 \tag{3}$$

$$Msp \propto WLT \tag{4}$$

$$Sxz \equiv \frac{Kx}{Kz} \propto \frac{W^2}{T^2} \tag{5}$$

where K is the spring constant;
T is the thickness;
L is the length;
W is the width;
Msp is the mass; and
Sxz is the cross axis sensitivity and lateral shock tolerance.

As demonstrated by equations (3), (4) and (5), the same spring constant K can be provided by using a given thickness T and length L or by using 2xT and 2xL. However, in the case of the double length L and double thickness T spring, the mass Msp is four times as large as the smaller version. Reducing the mass ratio between the folded beams **1415** and the mass **1405** reduces the spring resonant energy transfer from the folded beams **1415** to the mass **1405**. Moreover, by using a reduced thickness T for a given width W, an improved cross axis sensitivity and lateral shock tolerance Sxz is provided. Finally, using thinner folded beams **1415** for a given spring constant K provides first and second natural frequency spring resonances that are spread further apart spatially in the frequency spectrum.

In several alternative embodiments of folded beam (FB) springs, the following operational characteristics were provided:

| | SPRING THICKNESS RATIO | NORMALIZED SPRING MASS RATIO | NORMALIZED CROSS AXIS SENSITIVITY | SPRING MODE SEPARATION (KHz) | NORMALIZED INERTIAL ELEMENT/ SPRING COUPLING |
|---|---|---|---|---|---|
| FB spring 1 | 1.00 | 1.00 | 1.0 | 72.0 | 1.00 |
| FB spring 2 | 0.92 | 0.88 | 1.2 | 73.6 | -- |
| FB spring 3 | 0.75 | 0.60 | 1.8 | 87.6 | - |
| FB spring 4 | 0.72 | 0.56 | 1.9 | 92.0 | 0.44 |
| FB spring 5 | 0.60 | 0.40 | 2.8 | 109.0 | 0.37 |

All values are normalized to FB spring 1.

In an exemplary embodiment, the incorporation of the teachings of the assembly **1400** having folded beams **1415** into the accelerometer **305** provide an accelerometer having enhanced operational characteristics. In particular, optimally stable operation of the accelerometer 305 is provided by reducing the ratio of the mass of the spring element to the mass of the inertial element, as shown above. In this manner, the transfer of energy from the springs to the mass is minimized at the natural frequencies of the spring. In an exemplary embodiment, optimal closed-loop performance of the accelerometer **305** is provided when the first and second natural frequencies (or modes) of the springs are separated by at least about 80 kHz, as in the case of FB springs **3, 4,** and **5,** as shown above. In an exemplary embodiment, the separation of the first and second natural frequencies was increased by utilizing the folded beams **1415** versus a conventional L-shaped beam as demonstrated below.

| | SPRING THICKNESS RATIO | NORMALIZED SPRING MASS RATIO | SPRING MODE SEPARATION (KhZ) |
|---|---|---|---|
| L-SHAPED SPRING | 1.00 | 2.22 | 55.2 |
| FOLDED BEAM SPRING 6 | 1.00 | 1.00 | 80.16 |

All values are normalized to FB spring **6.**

Referring to **Fig. 14, 14c,** and **14d,** the inclusion of the circular cutouts **1445, 1450,** and **1455** in the folded beams **1415** further eliminate crack propagation that can be caused by typical manufacturing processes. In particular, during the manufacture of a folded beam **1415**, the webbing artifact **1465** from a conventional plasma etching process can induce crack propagation along a direction **1470** into the folded beam **1415**. The addition of circular cutouts to the folded beam **1415** minimizes webbing formation during the etching process. Referring to **Fig. 14e,** the inclusion of vent holes **1475** within the webbing artifact **1465** will also arrest the propagation of cracks along the direction **1470**.

Referring now to **FIG. 15,** an embodiment of an assembly **1500** for resiliently coupling a mass **1505** to a support **1510** using folded beams **1515a-1515d** will now be described.

Each folded beam **1515** includes an inner foot **1520** coupled to the mass **1505** and an outer foot **1525** coupled to the support **1510**. Extending from the feet **1520** and **1525** are corresponding inner and outer legs, **1530** and **1535,** that are joined by a head **1540**. The connection between the inner foot **1520** and the mass **1505** includes a circular cutout **1545,** the connection between the outer foot **1525** and the support **1510** includes a circular cutout **1550,** and the connection between the legs, **1530** and **1535,** and the head **1540** includes a circular cutout **1555.** The circular cutouts **1545, 1550,** and **1555** provide stress relief.

Range-of-movement stops **1560a-1560d** extend from corresponding interior comers of the support **1510** for limiting the range-of-motion of the mass **1505**. Each stop **1560** includes a motion capture portion **1565** positioned in opposing relation to a corresponding comer of the mass **1505** for limiting movement of the mass **1505** in the direction of the corresponding motion capture portion **1565**.

In a preferred embodiment, the teachings of the assembly **1500** are incorporated into the top measurement mass half **410** and the bottom measurement mass half **415** of the accelerometer **305** in order to optimally support the top measurement mass **906** and the bottom measurement mass **912** during operation of the accelerometer **305**. In a preferred embodiment, the first and second natural frequencies of the folded beams **1515a-1515d** are separated by at least about 80 kHz in order to provide optimally stable operation of the accelerometer **305**.

In an exemplary embodiment, the fabrication of the folded beams **1515** of the assembly **1500** are provided by utilizing a manufacturing process including a plasma etch process. A mask that includes the folded beams **1515** is patterned onto a silicon wafer and thereby serves to mask or expose the various regions of the silicon wafer in an etching process. The etching rate is typically not uniform throughout the silicon wafer and is dependent upon the size of the openings provided in the masking layer. However, uniformity and controllability of the process steps are desired during the manufacturing process. Thus, in order to equalize the etch rate and preserve uniformity across the silicon wafer, etch-buffers are included in the manufacturing process for the assembly **1500**. The etch-buffers provide the following benefits: (1) the area per unit length of the open areas of the mask are substantially constant; and (2) the entry of etch-gasses and the etching action on the backside of the folded beams **1515** are minimized. In an exemplary embodiment, the backside etching of the folded beams **1515** is reduced by approximately 1-2 microns. In this manner, variations in the thicknesses of the beams **1515** are minimized from die to die and wafer to wafer. In a preferred embodiment, the stops **1560** also act as etch buffers during the manufacturing of the assembly **1500.**

Referring to **Fig. 15a,** in an alternative embodiment, one or more of the stops **1560** include one or more perforations **1570** in order to minimize fluid damping of the mass **1505**.

Referring now to **FIG. 16,** an embodiment of an assembly **1600** for resiliently coupling a mass **1605** to a support **1610** using S-shaped beams **1615a-1615d** will now be described.

Each S-shaped beam **1615** includes an inner foot **1620** coupled to the mass **1605** and an outer foot **1625** coupled to the support **1610**. Extending between the feet is an S-shaped member **1630**. In a preferred embodiment, the mass of the S-shaped member **1630** that overhangs on each side of the feet **1620** and **1625** is approximately equal in order to provide an optimally balanced suspended folded-beam structure having reduced tilt.

Range-of-movement stops **1635a-1635d** extend from corresponding interior comers of the support **1610** for limiting the range-of-motion of the mass **1605**. Each stop **1635** includes a motion capture portion **1640** positioned in opposing relation to a corresponding comer of the mass **1605** for limiting movement of the mass **1605** in the direction of the corresponding motion capture portion **1640**.

In an alternate embodiment, the teachings of the assembly **1600** are incorporated into the top measurement mass half **410** and the bottom measurement mass half **415** of the accelerometer **305** in order to optimally support the top measurement mass **906** and the bottom measurement mass **912** during operation of the accelerometer **305**. In an alternate embodiment, the first, second and third natural frequencies of the S-shaped beams **1615a-1615d** are separated by less than about 2 to 36 kHz in order to provide optimally stable operation of the accelerometer **305.**

Referring now to **FIG. 17**, an embodiment of an assembly **1700** for resiliently coupling a mass **1705** to a support **1710** using S-shaped beams **1715a-1715d** will now be described.

Each S-shaped beam **1715** includes an inner foot **1720** coupled to the mass **1705** and an outer foot **1725** coupled to the support **1710**. Extending between the feet is an S-shaped member **1730**. In a preferred embodiment, the mass of the S-shaped member **1730** that overhangs on each side of the feet **1720** and **1725** is approximately equal. Range-of-movement stops **1731, 1732, 1733** and **1734** extend from the opposite ends of the S-shaped member **1730** in order to limit the range-of-motion of the mass **1705**.

Range-of-movement stops **1735a-1735d** extend from corresponding interior corners of the support **1710** for limiting the range-of-motion of the mass **1705**. Each stop **1735** includes a motion capture portion **1740** positioned in opposing relation to a corresponding corner of the mass **1705** for limiting movement of the mass **1705** in the direction of the corresponding motion capture portion **1740**.

In an alternate embodiment, the teachings of the assembly **1700** are incorporated into the top measurement mass half **410** and the bottom measurement mass half **415** of the accelerometer **305** in order to optimally support the top measurement mass **906** and the bottom measurement mass **912** during operation of the accelerometer **305**. In an alternate embodiment, the first, second and third natural frequencies of the S-shaped beams **1715a-1715d** are separated by less than about 2 to 36 kHz in order to provide optimally stable operation of the accelerometer **305.**

Referring now to **FIG. 18,** an embodiment of an assembly **1800** for resiliently coupling a mass **1805** to a support **1810** using folded beams **1815a-1815d** will now be described.

Each folded beam **1815** includes an inner foot **1820** coupled to the mass **1805** and an outer foot **1825** coupled to the support **1810**. Extending from the feet **1820** and **1825** are corresponding inner and outer legs, **1830** and **1835,** that are joined by a head **1840**. The connection between the inner foot **1820** and the mass **1805** includes a circular cutout **1845,** the connection between the outer foot **1825** and the support **1810** includes a circular cutout **1850,** and the connection between the legs, **1830** and **1835,** and the head **1840** includes a circular cutout **1855**. The circular cutouts **1845, 1850,** and **1855** provide stress relief.

Range-of-movement stops **1860a-1860d** extend from corresponding sides of the support **1810** for limiting the range-of-motion of the mass **1805** in the direction of the corresponding stop **1860.**

In a preferred embodiment, the teachings of the assembly **1800** are incorporated into the top measurement mass half **410** and the bottom measurement mass half **415** of the accelerometer **305** in order to optimally support the top measurement mass **906** and the bottom measurement mass **912** during operation of the accelerometer **305**. In a preferred embodiment, the first and second natural frequencies of the folded beams **1815a-1815d** are separated by at least about 80 kHz in order to provide optimally stable operation of the accelerometer **305**.

Referring now to **FIG. 19,** an embodiment of an assembly **1900** for resiliently coupling a mass **1905** to a support **1910** using folded beams **1915a-1915d** will now be described.

Each folded beam **1915** includes an inner foot **1920** coupled to the mass **1905** and an outer foot **1925** coupled to the support **1910**. Extending from the feet **1920** and **1925** are corresponding inner and outer legs, **1930** and **1935,** that are joined by a head **1940**. The connection between the inner foot **1920** and the mass **1905** includes a circular cutout **1945**, the connection between the outer foot **1925** and the support **1910** includes a circular cutout **1950**, and the connection between the legs, **1930** and **1935**, and the head **1940** includes a circular cutout **1955.** The circular cutouts **1945, 1950,** and **1955** provide stress relief. The head **1940** further includes an etch buffer **1960**.

Range-of-movement stops **1965a-1965d** extend from corresponding sides of the support **1910** for limiting the range-of-motion of the mass **1905** in the direction of the corresponding stop **1965.**

In a preferred embodiment, the teachings of the assembly **1900** are incorporated into the top measurement mass half **410** and the bottom measurement mass half **415** of the accelerometer **305** in order to optimally support the top measurement mass **906** and the bottom measurement mass **912** during operation of the accelerometer **305**. In a preferred embodiment, the first and second natural frequencies of the folded beams **1915a-1915d** are separated by at least about 80 kHz in order to provide optimally stable operation of the accelerometer **305.**

In several alternative embodiments, the folded beams **1415, 1515, 1815** and **1915** include one or more integral range-of-motion stops for limiting the range-of-movement of the corresponding mass. In this manner, a compact resilient structure is provided that includes a built-in range-of-motion stop.

Referring now to **FIG. 20**, an embodiment of an assembly 2000 for resiliently coupling a mass **2005** to a support **2010** using straight beams **2015a-2015d** will now be described.

Each straight beam **2015** is coupled to a corresponding side of the mass **2005** and a corresponding side of the support **2010**.

Range-of-movement stops **2020a-2020d** extend from corresponding corners of the support **2010** for limiting the range-of-motion of the mass **2005** in the direction of the corresponding stop **2020**.

The straight beams **2015** provide enhanced lateral shock tolerance, vertical compliancy, and high lateral stiffness.

In a preferred embodiment, the teachings of the assembly **2000** are incorporated into the top measurement mass half **410** and the bottom measurement mass half **415** of the accelerometer **305** in order to optimally support the top measurement mass **906** and the bottom measurement mass **912** during operation of the accelerometer **305**. In a preferred embodiment, the first and second natural frequencies of the straight beams **2015a-2015d** are separated by at least about 80 kHz in order to provide optimally stable operation of the accelerometer **305**.

Referring now to **FIG. 21,** an embodiment of an assembly 2100 for resiliently coupling a mass **2105** to a support **2110** using folded beams **2115a-2115d** will now be described.

Each folded beam **2115** includes an inner foot **2120** coupled to the mass **2105** and an outer foot **2125** coupled to the support **2110**. Extending from the feet **2120** and **2125** are corresponding inner and outer legs, **2130** and **2135**, that are joined by a head **2140**. The connection between the inner foot **2120** and the mass **2105** includes a circular cutout **2145**, the connection between the outer foot **2125** and the support **2110** includes a circular cutout **2150,** and the connection between the legs, **2130** and **2135,** and the head **2140** includes a circular cutout **2155**. The circular cutouts **2145, 2150,** and **2155** provide stress relief. A support arm **2160** extends from head **2140** that supports a mass **2165** for dampening out the resonance of the folded beam **2115**.

In a preferred embodiment, the frequency response of a first portion of the folded beams **2115** including the feet, **2120** and **2125**, the legs, **2130** and **2135**, and the head **2140** is out of phase with the frequency response of a second portion of the folded beams **2115** including the support arm **2160** and the mass **2165**. In this manner, the resonances of the first and second portions of the folded beams **2115** destructively interfere with one another thereby reducing the overall resonance of the folded beams **2115**. In this manner, the transmission of resonant energy from the folded beams **2115** to the mass **2105** is reduced.

In a preferred embodiment, the teachings of the assembly **2100** are incorporated into the top measurement mass half **410** and the bottom measurement mass half **415** of the accelerometer **305** in order to optimally support the top measurement mass **906** and the bottom measurement mass **912** during operation of the accelerometer **305**. In a preferred embodiment, the first and second natural frequencies of the folded beams **2115a-2115d** are separated by at least about 80 kHz in order to provide optimally stable operation of the accelerometer **305**.

Referring now to **FIG. 22**, an embodiment of an assembly **2200** for resiliently coupling a mass **2205** to a support **2210** using folded beams **2215a-2215d** will now be described.

Each folded beam **2215** includes an inner foot **2220** coupled to the mass **2205** and an outer foot **2225** coupled to the support **2210**. Extending from the feet **2220** and **2225** are corresponding inner and outer legs, **2230** and **2235,** that are joined by a head **2240**. The connection between the inner foot **2220** and the mass **2205** includes a circular cutout **2245,** the connection between the outer foot **2225** and the support **2210** includes a circular cutout **2250,** and the connection between the legs, **2230** and **2235,** and the head **2240** includes a circular cutout **2255**. The circular cutouts **2245, 2250,** and **2255** provide stress relief.

Soft stop members **2260a-2260h** extend from the interior walls of the support **2210** for compliantly limiting movement of the mass **2205** in the direction of the soft stop members **2260a-2260h.**

The soft stop members **2260** of the assembly **2200** provide optimal lateral shock tolerance. In this manner, shock loading of the mass **2205** due to excessive displacement is prevented. During operation of the assembly **2200**, when a high shock impulse is applied to the mass **2205**, the mass **2205** accelerates and contacts one or more of the soft stop members **2260**. Any subsequent motion of the mass **2205** is retarded by the stiffness factor of the folded beams **2215.** Furthermore, the soft-contact members **2260** also minimize chipping of material from the mass **2205** and/ or range-of-motion stops during high G shock levels.

In a preferred embodiment, the teachings of the assembly **2200** are incorporated into the top measurement mass half **410** and the bottom measurement mass half **415** of the accelerometer **305** in order to optimally support the top measurement mass **906** and the bottom measurement mass **912** during operation of the accelerometer **305**. In a preferred embodiment, the first and second natural frequencies of the folded beams **2215a-2215d** are separated by at least about 80 kHz in order to provide optimally stable operation of the accelerometer **305**.

Referring now to **FIG. 23,** an embodiment of an assembly **2300** for resiliently coupling a mass **2305** to a support **2310** using folded beams **2315a-2315d** will now be described.

Each folded beam **2315** includes an inner foot **2320** coupled to the mass **2305** and an outer foot **2325** coupled to the support **2310**. Extending from the feet **2320** and **2325** are corresponding inner and outer legs, **2330** and **2335,** that are joined by a head **2340**. The connection between the inner foot **2320** and the mass **2305** includes a circular cutout **2345**, the connection between the outer foot **2325** and the support **2310** includes a circular cutout **2350**, and the connection between the legs, **2330** and **2335**, and the head **2340** includes a circular cutout **2355.** The circular cutouts **2345, 2350**, and **2355** provide stress relief.

Tethers **2360a-2360d** extend between the comers of the mass **2305** and opposing interior comers of the support **2310** for limiting movement of the mass **2305**.

The folded beams **2315** and tethers **2360** of the assembly **2300** provide optimal lateral shock tolerance, vertical compliancy, and high lateral stiffness.

In a preferred embodiment, the teachings of the assembly **2300** are incorporated into the top measurement mass half **410** and the bottom measurement mass half **415** of the accelerometer **305** in order to optimally support the top measurement mass **906** and the bottom measurement mass **912** during operation of the accelerometer **305**. In a preferred embodiment, the first and second natural frequencies of the folded beams **2315a-2315d** are separated by at least about 80 kHz in order to provide optimally stable operation of the accelerometer **305.**

In a preferred embodiment, the folded beams **1415, 1515, 1815, 1915, 2115, 2215,** and **2315,** the S-shaped beams **1615,** and **1715,** and the straight beams **2015** of the assemblies **1400, 1500, 1600, 1700, 1800, 1900, 2000, 2100, 2200,** and **2300.** are formed by a plasma etch process. In particular, a mask that includes the folded beam, the S-shaped beam, or the straight beam shape is patterned on a silicon wafer in order to mask or expose the various regions on the wafer to an etchant. In several alternative embodiments, the assemblies **1400, 1500, 1600, 1700, 1800, 1900, 2000, 2100, 2200,** and **2300** are formed using a merged mask micro-machining process substantially as disclosed in one or more of the following: U.S. Patent Application serial no. 09/352,835, attorney docket number 14737.659.02, filed on July 13, 1999, and U.S. Patent Application serial no. 09/352,025, attorney docket number 14737.659.03, filed on July 13, 1999, the disclosures of which are incorporated herein by reference.

It is understood that variations may be made in the foregoing without departing from the scope of the invention. For example, one or more of the stops **1560, 1635, 1735, 1860, 1965, 2020,** may include one or more perforations for minimizing fluid damping. Furthermore, the stops **1560, 1635, 1735, 1860, 1965,** and **2020** may also be used to provide etch-buffers to minimize etch variation and backside etching during the manufacture of the assemblies **1500, 1600, 1700, 1800, 1900,** and **2000.** In addition, the teachings of the assemblies **1500, 1600, 1700, 1800, 1900, 2000, 2100, 2200,** and **2300** may be incorporated into any of the other assemblies, in whole, or in part.

The present embodiments of the invention provide an accelerometer for providing reliable data measurements. The accelerometer includes a measurement mass that is resiliently coupled to a housing by using a folded beam, an S-shaped beam or a straight beam. In this manner, the accelerometer provides a low noise floor as well as optimal operational stability over a wide range of temperatures. The accelerometer further includes range-of-motion limit stops for limiting motion of the measurement mass in the lateral direction thereby enhancing the cross-axis sensitivity and lateral shock tolerance of the accelerometer.

In a preferred embodiment the accelerometer of the present invention is tuned to operate with a controller in a closed-loop configuration. **Figure 24** shows a functional block diagram of an exemplary closed-loop configuration operation **2400**. A sensor **2410** made according to the present invention (as described above in reference to **Figs. 1-23)** is electrically coupled to a controller **2420** which preferably is a sigma-delta controller. The operation of such controllers are known in the art and is thus not described in detail here. The operation of the controller may be found in U.S. Patent No. 6,023,960 to Atorame et al., U.S. Patent No. 5,852,242 to Develok et al., and U.S. Patent No. 4,922,756 to Henrion, each assigned to the assignee of this application and incorporated herein by reference. In operation, the movement of the mass **2412** from its normal or neutral position that occurs due to acceleration of the mass generates an analog signal **2416** which represents change in capacitance, which signal is received by the controller **2420**. The controller **2420** applies a voltage sufficient to move the mass **2412** back to its neutral position. The applied voltage thus is proportional to the acceleration detected by the sensor **2410.** The applied voltage signal is digitized by an analog-to-digital (A/D) converter **2430** to provide a digital signal proportional to the acceleration detected by the sensor **2410.** A power supply **2440** provides the required electrical energy to the controller and the A/D converter. In a preferred embodiment, the A/D converter is an integral part of the controller **2420**. The controller **2420** and the accelerometer **2410** are preferably packaged as a unit.

The inventors of the present invention have found that the controllers in general and sigma-delta controllers in particular designed to use with the accelerometer of the present invention provide stable operation within certain predetermined frequency bands, sometimes referred to as the "sweet spots." The mass **2412** and/or the springs **2414** can have several mechanical vibrational modes and each such mode can occur at a different frequency. Therefore, in order to optimally utilize the accelerometer **2410** with the controller **2420**, it is necessary to tune the frequencies of these mechanical vibrational modes in the Z-axis **(Fig. 6)** so that these frequencies lie within one or more of the stable frequency bands of the controller **2420**, i.e., in one or more of the sweet spots.

The inventors of the present invention have also found that the shape of the springs **2414** is a dominant factor to tune the mechanical vibrational frequencies of the mass **2412**. The size (dimension) and mass of the springs also affect the frequencies. The inventors of the present invention have found that folded springs or s-shaped springs (as described above) are preferred. In one embodiment, the shape, size and/or mass of these springs are selected so that the induced mechanical vibration frequencies in the mass **2410** by such springs lie within one or more of the sweet spots of the chosen controller. The size, shape and mass are further selected so that the springs are resilient and robust, i.e. they are able to withstand high shock values.

The inventors of the present invention have further found that the mass of the springs **2414** is a significant contributor to the amplitude of the induced mechanical vibrational modes of the mass **2412.** It is also known that a controller, such as the controller **2420,** usually is unaffected by induced mechanical vibrational modes of the sensor below a certain level (threshold or limit). Laboratory tests have shown that the mass of the springs **2414** is a significant contributor to the amplitude of the mechanical vibration. Thus, in a preferred embodiment of the present invention, the mass of the springs **2414** is chosen so that the amplitude of the mechanical vibration of the sensor approaches or remains below the threshold level of the controller.

In a preferred embodiment, folded beam-type or s-shaped springs are used to support the mass **2412.** The shape, size (dimension) and the mass of such springs are selected so that the mechanical vibration frequencies of the sensor lies within one or more of the frequency bands (sweet spots) of the mating controller and the amplitude of the mechanical vibration remains below the threshold level of the controller **2420**. In this manner, the present invention provides a sensor package **2400** whose entire output substantially corresponds to the acceleration of mass **2412** and that it operates reliably over wide ranges of temperature.

Although illustrative embodiments of the invention have been shown and described, a wide range of modification, changes and substitution is contemplated in the foregoing disclosure. In some instances, some features of the present invention may be employed without a corresponding use of the other features. Accordingly, it is appropriate that the appended claims be construed broadly and in a manner consistent with the scope of the invention.

**Claims**

1. A method of preventing crack propagation in a micro-machined structure including a webbing artifact, comprising:

   providing one or more holes within the webbing artifact.

2. A method of minimizing backside etching of elements within a micro-machined structure, comprising:

   providing one or more etch-buffers adjacent to the elements.

3. A method of improving the dimensional uniformity of elements within a micro-machined structure, comprising:

   providing one or more etch-buffers adjacent to the elements.

4. A method of protecting a mass supported within a support structure by one or more springs, comprising:

   providing one or more soft-contact bumpers for preventing impacts between the mass and the support structure.

5. A sensor package, comprising:

   a sensor having a mass suspended by a plurality of springs which induce mechanical vibrational modes in the sensor, the sensor providing an output signal indicative of acceleration detected by the mass; and
   a controller coupled to the sensor in a closed-loop configuration, the controller in response to the output signal of the sensor providing a digital output proportional to the acceleration detected by the sensor, the controller in the closed-loop operation having at least one predefined frequency band for stable operation relative to the frequency of mechanical vibrational modes induced in sensor;

   wherein the plurality of springs are tuned so that the frequency of the induced mechanical vibrational modes remains substantially within at least one predetermined frequency band.

6. The sensor package of claim 5, wherein the sensor is tuned by selecting one of: (i) shape of the springs; (ii) mass of the springs; (iii) size (dimensions) of the springs; and (iv) a combination of at least two of the shape, size and mass of the springs.

7. The sensor package of claim 5, wherein the springs are selected from a group consisting of: (i) folded beam springs; and (ii) s-shaped springs.

8. The sensor package of claim 5, wherein the springs are further selected to maintain a spring constant within a predetermined range.

9. The sensor package of claim 8, wherein the spring constant is selected as a function of at least one of:

   (i) sensitivity and frequency response of the sensor;
   (ii) dynamics range of the sensor output; and (iii) desired shock tolerance of the sensor.

10. A sensor package, comprising:

    a sensor having a mass suspended from a structure by a plurality of springs which induce mechanical vibrational modes in at least one direction of movement of the mass, the amplitude of the induced mechanical vibrational modes being a function of the mass of the springs; and
    a controller coupled to the sensor in a closed loop operation for providing a digital output proportional to the acceleration detected by the sensor, the controller having a predetermined amplitude threshold level for detecting any mechanical vibrational modes of the sensor;

    wherein the mass of the springs is selected so that the amplitude of the mechanical vibrational modes induced in the sensor remains below the predetermined amplitude threshold level of the controller.

11. The sensor package of claim 10, wherein the springs are selected from a group consisting of: (i) folded beam springs; and (ii) s-shaped springs.

12. The sensor package of claim 10, wherein the controller further includes at least one predefined frequency band for stable operation relative to frequency of a mechanical vibrational mode induced by said springs and wherein said springs are tuned so that the frequency of the induced mechanical vibrational mode remains within the at least one predefined frequency band.

13. The sensor package of claim 12, wherein the springs are further selected to provide a stable operation of the sensor over a selected temperature range.

FIGURE 1

*FIGURE 2*

*FIGURE 3a*

FIGURE 3b

EP 1 408 336 A2

FIGURE 4

FIGURE 5

420
415
410
405

305

FIGURE 6

EP 1 408 336 A2

405

735    725    730    406    725    735

407

715

d2    w1    720    705    720    715    408    707    710

710    707

d1

**FIGURE 7a**

FIGURE 7b

**FIGURE 7c**

**FIGURE 7d**

**FIGURE 7e**

**FIGURE 7f**

**FIGURE 7g**

**FIGURE 7h**

**FIGURE 7i**

**FIGURE 7j**

**FIGURE 7k**

**FIGURE 7l**

EP 1 408 336 A2

FIGURE 8a

FIGURE 8b

EP 1 408 336 A2

FIGURE 8c

EP 1 408 336 A2

FIGURE 9a

EP 1 408 336 A2

**FIGURE 9aa**

**FIGURE 9ab**

FIGURE 9ac

**FIGURE 9ad**

**FIGURE 9b**

EP 1 408 336 A2

FIGURE 9c

FIGURE 9d

**FIGURE 9e**

FIGURE 9f

FIGURE 9g

EP 1 408 336 A2

```
┌──────────────┐                      ┌──────────────┐
│ Two Starting │                      │ Two Starting │
│  Cap Wafers  │                      │ Mass Wafers  │
└──────────────┘                      └──────────────┘
 1005                                              1020
        │                                    │
        ▼                                    ▼
┌──────────────┐                      ┌──────────────┐
│  Cap Wafer   │                      │  Mass Wafer  │
│   Process    │                      │   Process    │
└──────────────┘                      └──────────────┘
 1010                                              1025
        │                                    │
        └────────────────┬───────────────────┘
                         ▼
              ┌──────────────────┐
              │ Bonding Process  │
              └──────────────────┘
                              1035
                         │
                         ▼
              ┌──────────────────┐
              │  Dicing Process  │
              └──────────────────┘
                              1040
                         │
                         ▼
              ┌──────────────────┐
              │   Packaging      │
              │    Process       │
              └──────────────────┘
                              1045
```

1000

**FIGURE 10**

FIGURE 11a

FIGURE 11b

FIGURE 11c

**FIGURE 11d**

EP 1 408 336 A2

FIGURE 11e

FIGURE 11f

EP 1 408 336 A2

*1130*

*1140a*

*950*

*410*

*415*

*1140b*

**FIGURE 11g**

FIGURE 11h

**FIGURE 11ha**

**FIGURE 11hb**

FIGURE 11hc

FIGURE 11hd

FIGURE 11he

FIGURE 11hf

FIGURE 11hg

FIGURE 11hh

FIGURE 11hi

FIGURE 11hj

**FIGURE 11i**

FIGURE 11j

FIGURE 12a

FIGURE 12b

FIGURE 12c

**FIGURE 13**

1310

1305

305

950

**FIGURE 14**

1415

**FIGURE 14a** .

1415

**FIG. 14b**

1415

14d,14e

**FIGURE 14c**

1415

1465

1470

**FIGURE 14d**

FIGURE 14e

**FIGURE 15**

FIGURE 15A

**FIGURE 16**

**FIGURE 17**

FIGURE 18

FIGURE 19

FIGURE 20

**FIGURE 21**

EP 1 408 336 A2

FIGURE 22

77

*2300*

*2350a*
*2330a* *2325a*
*2340a* *2315a* *2345a* *2310*
*2355a* *2335a* *2320a*

*2360d*
*2360a*

*2305*

*2345d*
*2320d*
*2325d*
*2350d*
*2330d*
*2315d*
*2335d*
*2355d*
*2340d*

*2340b*
*2355b*
*2335b*
*2315b*
*2330b*
*2350b*
*2325b*
*2320b*
*2345b*

*2360c*

*2345c* *2320c* *2315c* *2340c* *2360b*
*2325c* *2330c* *2355c*
*2335c*
*2350c*

**FIGURE 23**

*FIGURE 24*

EP 1 408 336 A2